# EUROPEAN PATENT SPECIFICATION

(11) **EP 2 762 605 B1**
(45) Date of publication and mention of the grant of the patent: **06.05.2020**
(21) Application number: 12834758.0
(22) Date of filing: 26.09.2012
(51) Int. Cl.: C23C 14/24, C23C 14/02, C23C 14/22, C23C 14/54, C23C 14/58, C23C 14/00

(54) **FILM FORMATION METHOD AND FILM FORMATION APPARATUS**
FILMFORMUNGSVORRICHTUNG UND FILMFORMUNGSVERFAHREN
PROCÉDÉ DE FORMATION DE FILM ET APPAREIL DE FORMATION DE FILM

(30) Priority: 30.09.2011 WO PCT/JP2011/072586; 10.02.2012 WO PCT/JP2012/053099; 02.08.2012 WO PCT/JP2012/069714
(43) Date of publication of application: 06.08.2014
(73) Proprietor: Shincron Co., Ltd., Kanagawa 220-8680 (JP)
(72) Inventor: SHIONO, Ichiro, Yokohama-shi Kanagawa 220-8680 (JP); HAYASHI, Tatsuya, Yokohama-shi Kanagawa 220-8680 (JP); JIANG, Yousong, Yokohama-shi Kanagawa 220-8680 (JP); NAGAE, Ekishu, Yokohama-shi Kanagawa 220-8680 (JP); MIYAUCHI, Mitsuhiro, Yokohama-shi Kanagawa 220-8680 (JP); SAMORI, Shingo, Yokohama-shi Kanagawa 220-8680 (JP)
(74) Representative: Strehl Schübel-Hopf & Partner
(86) International application number: PCT/JP2012/074755
(87) International publication number: WO 2013/047605

(56) References cited:
- WO-A1-2010/018876
- JP-A- H1 171 671
- JP-A- S6 421 973
- JP-A- H04 280 967
- JP-A- H10 330 940
- JP-A- S61 288 064
- JP-A- 2005 232 534
- JP-A- 2006 022 368
- JP-A- 2007 224 335
- JP-A- 2010 090 454
- US-A1- 2011 151 135
- HYUN JU CHO ET AL.: 'Optical inhomogeneity and microstructure of Zr02 thin films prepared by ion-assisted deposition' APPLIED OPTICS vol. 35, no. 28, 01 October 1996, pages 5545 - 5552, XP055064644

## Description

### TECHNICAL FIELD

The present invention relates to a film formation method and a film formation apparatus suitable for a variety of film formation of optical thin films and functional thin films, etc. in particular.

### BACKGOUND ART

In the field of optical thin films (including antireflection films) used for optical materials, such as an optical lens and optical filter, a slight decline in the optical characteristics thereof leads to a serious decline in characteristics as a final product. Therefore, an improvement of optical characteristics (for example, light transmissivity, etc.) has been demanded on optical thin films.

There is known a technique of forming an anti-fouling film as an example of a functional thin film by going through the steps below (patent document 1). The method is to hold a plurality of substrates as processing objects allover a substrate holding surface of a substrate holder, then, to rotate the substrate holder in a vacuum chamber. Next, while maintaining the rotation, ions were irradiated continuously toward all of the plurality of substrates (ion irradiation to whole surface), then, a film formation material composed of materials for forming anti-fouling films is evaporated to adhere to all of the substrates having textured surfaces formed thereon by ion irradiation (supply of film formation material to whole surface). The method is to deposit an anti-fouling film on a textured surface of all of a plurality of substrates from the steps above. According to the method, it is possible to form an anti-fouling film having enough wear resistance for practical use (paragraph [0029] in the patent document 1). In recent years, furthermore improvements of wear resistance are demanded on anti-fouling films.

### RELATED ART DOCUMENTS

### PATENT DOCUMENTS

Patent Document 1: Japanese Patent Unexamined Publication (KOKAI) No. 2010-90454

The two-part form of present claim 1 is based on JP H04 280967 A. Other prior art examples are disclosed in US 2011/151135 A1, WO 2010/018876 A1, JP S61 288064 A, JP 2005 232534 A, JP H11 71671 A, JP H10 330940 A, JP 2006 022368 A, JP 2007 224335 A, JP 2010 090454 A, JP S64 21973 A, and in the paper "Optical inhomogeneity and microstructure of ZrO2 thin films prepared by ion-assisted deposition", by Hyun Ju Cho et al., Applied Optics, Vol. 35, No. 28, pages 5545-5552.

### SUMMARY OF THE DISCLOSED SUBJECT MATTER

According to an aspect of the present disclosure, a film formation method and a film formation apparatus capable of improving various performances of a variety of thin films are provided. According to another aspect of the present disclosure, a film formation method and a film formation apparatus capable of efficiently forming an optical thin film having improved optical characteristics are provided. According to still another aspect of the present disclosure, a film formation method and a film formation apparatus capable of efficiently forming a functional thin film having improved wear resistance, water repellency, oil repellency and anti-fouling characteristics, etc. are provided.

According to the first aspect of the present-disclosure, there is provided a film formation method for depositing a thin film on a surface of a basal body, characterized by using
a rotatable basal body holding means having a basal body holding surface for holding a plurality of basal bodies, and
a film formation means arranged to be able to supply a larger amount of a film formation material of the thin film to a first area that is a partial area of the basal body holding surface than to an area other than the first area when operated toward the basal body holding means in a rotation stop state;
wherein, by operating the film formation means continuously while rotating the basal body holding means in a state of holding a plurality of basal bodies on the basal body holding surface and changing a supply amount of the film formation material to all or a part of moving basal bodies over time, the thin film formed by the film formation material is deposited.

When depositing a thin film on a surface of each of a plurality of basal bodies moving along with rotation of a basal body holding means, an assisted effect may be given by irradiating energetic particles to a partially supplied film formation material. Irradiation of energetic particles may be an irradiation to the whole surface toward a third area (for example A1), that is the whole area of the basal body holding surface, when operated toward the basal body holding means in a rotation stop state. However, when operated toward a basal body holding means in a rotation stop state, partial irradiation only toward a second area (for example A2), that is a partial area of the basal body holding surface, is preferable.

Namely, according to a second aspect of the present-disclosure, there is provided a film formation method for depositing a thin film on a surface of a basal body, characterized by using
a rotatable basal body holding means having a basal body holding surface for holding a plurality of basal bodies,
a film formation means arranged to be able to supply a larger amount of a film formation material of the thin film to a first area (for example, A3) that is a partial area of the basal body holding surface than to an area (remaining area) other than the first area when operated toward the basal body holding means in a rotation stop state, and
an irradiation means for irradiating energetic particles only toward a second area (for example, A2) that is a partial area of the basal body holding surface when operated toward the basal body holding means in a rotation stop state;
wherein, by operating the film formation means and the irradiation means continuously while rotating the basal body holding means in a state of holding a plurality of basal bodies on the basal body holding surface and changing a supply amount of the film formation material to all or a part of moving basal bodies over time and temporarily securing time of not irradiating the energetic particles to all or a part of basal bodies, the thin film formed by the film formation material and provided with an assisted effect is deposited.

An irradiation means of the present disclosure is used as at least either one of (1) and (2) below. Preferably, it is used as at least (1) below.
(1) film formation assist means for giving an assisted effect during thin film deposition and is operated together with a film formation means
(2) cleaning means for cleaning surfaces of basal bodies as film formation objects and is operated before starting operation of a film formation means

In the film formation method according to the second aspect of the present disclosure, a first area (A3) to be supplied with a film formation material may be an identically arranged as a second area (A2) to be irradiated with energetic particles for giving an assisted effect during thin film deposition. Alternatively, it may be arranged differently. Furthermore, one area (A2 or A3) may be arranged to be overlapping with at least a part of another area (A3 or A2). "Overlapping with at least one part" intends to include the case where one area overlaps with all of the other area.

Energetic particles with an accelerating voltage of 50 to 1500V may be used and/or energetic particles with an irradiation current of 50 to 1500mA may be used. Energetic particles including at least oxygen may be used. As energetic particles, in addition to an ion beam irradiated from an ion source, plasma irradiated from a plasma source, etc. may be also used.

According to the present disclosure, there is provided a film formation apparatus, wherein a basal body holding means having a basal body holding surface for holding a plurality of basal bodies is provided to be rotatable about a vertical axis in a vacuum container, comprising:
a film formation means provided in the vacuum container and configured to be able to supply a larger amount of a film formation material to a first area (for example, A3) that is a partial area of the basal body holding surface than to an area (remaining area) other than the first area when operated toward the basal body holding means in a rotation stop state, and
an irradiation means provided inside the vacuum container in the configuration, an arrangement and/or direction that energetic particles may be irradiated only toward a second area (for example, A2) that is a partial area of the basal body holding surface when operated toward the basal body holding means in a rotation stop state.

In the present disclosure, a film formation means may be configured only by a film formation source without depending on a blocking effect of a blocking plate, such as a correction plate. In that case, a film formation source may be arranged to be approached to the edge side from an approximate center arrangement in a lower portion in the vacuum container, so that a film formation material to be discharged may be supplied to half or less (alternatively, 50% or greater and 80% or less) of a third area (for example, A1) that is the whole area of the basal body holding surface of the basal body holding means.

When arranging a film formation source to be approached to the edge side in a lower portion of the vacuum container, an angle of a line connecting the center of a film formation source and the farthest point of an outer edge of a basal body holding means with respect to a reference line along the vertical direction of extending a vertical axis as a rotation center of a basal body holding means becomes 40 degrees or larger.

In the present disclosure, an irradiation means may be provided in the vacuum container in an arrangement that energetic particles may be irradiated toward not more than a half (alternatively, 50% or greater and 80% or less) of a third area (for example, A1) that is the whole area of the basal body holding surface of the basal body holding means.

In the present disclosure, an irradiation means may be configured by an irradiation source capable of irradiating energetic particles with an accelerating voltage of 50 to 1500V and/or energetic particles with an irradiation current of 50 to 1500mA. As an irradiation source, an ion source for irradiating an ion beam and a plasma source for irradiating plasma, etc. may be mentioned.

In the film formation apparatus of the present-disclosure, a first area (A3) to be supplied with a film formation material may be an identically arranged as a second area (A2) to be irradiated with energetic particles. Alternatively, it may be arranged differently. Furthermore, one area (A2 or A3) may be arranged to be overlapping with at least a part of another area (A3 or A2). "Overlapping with at least one part" intends to include the case where one area overlaps with all of the other area.

In the present disclosure, a rotation means for rotating the basal body holding means is furthermore provided, and the irradiation means may be provided inside the vacuum container in such a manner that an axis line of irradiating energetic particles form the irradiation means has an angle of 6 degrees or larger and 70 degrees or smaller with respect to an axis line of rotation of the basal body holding means. In the present disclosure, the irradiation means may be provided on the side surface side of the vacuum container, and the irradiation means may be provided in such a manner that a distance from basal bodies to be held on the basal body holding surface to the irradiation means during film formation becomes not longer than a mean free path. In the present disclosure, the irradiation means may be attached to a side surface of the vacuum container via a support means at least capable of adjusting an attachment angle.

In the present disclosure, the basal body holding means has a plate shape, dome shape or a pyramid shape and, in the case where a through hole penetrating from one surface thereof to another surface is formed, basal bodies to be held on the basal body holding surface during film formation may be held by the basal body holding means so as to block the through hole. In the present disclosure, a heating means for heating basal bodies and the basal body holding means may be furthermore provided.

According to the present disclosure, a film formation means is used, which is provided in a vacuum container and configured to be able to supply a larger amount of a film formation material to a first area that is a partial area of the basal body holding surface than to an area other than the first area when operated toward the basal body holding means while an operation of a rotatable basal body holding means having a basal body holding surface for holding a plurality of basal bodies as film formation objects is in a rotation stop state (rotation stop). The film formation means is operated continuously while rotating the basal body holding means in a state a plurality of basal bodies are held on the basal body holding surface (partial supply of film formation material). Thereby, a thin film made of the film formation material is deposited on a surface of each basal body while changing a supply amount of the film formation material to all or a part of the moving basal bodies over time.

According to the present disclosure, a film formation material is supplied at a high density in a pulse-like way in terms of time to all or a part of moving basal bodies. This film formation material supply at a high density in a pulse-like way accelerates activation of an energy state on the respective basal body surfaces. After that, the possibility becomes high that surfaces of the respective basal bodies reach a thermal equilibrium state (thermalization) through multiparticle interaction. Consequently, comparing with the conventional method of supplying a film formation material to all of a plurality of basal bodies, which are held on a basal body holding surface and rotating, (a film formation material supply to the whole surface), a bonding force between a basal body and a thin film to be deposited thereon can be stronger, therefore, a thin film having various excellent characteristics (wear resistance in a functional thin film and optical characteristics in an optical thin film) can be formed on each basal body surface.

According to a preferable mode of the present disclosure, in addition to the specific film formation means explained above, an irradiation means is furthermore used for irradiating energetic particles only toward a partial area (second area) of the basal body holding surface when operated toward the basal body holding means while an operating of the basal body holding means is suspended (rotation stop). And both of the film formation means and the irradiation means are operated continuously while rotating the basal body holding means in a state of holding a plurality of basal bodies on the basal body holding surface (a partial supply of a film formation material and partial irradiation of energetic particles). As a result, while changing a supply amount of a film formation material to all or a part of moving basal bodies over time as well as temporarily securing time of not irradiating energetic particles to all or a part of the basal bodies, the thin film made by the film formation material and provided with an assisted effect is deposited on a surface of each basal body.

According to this mode, in addition to the effect brought by a partial supply of the film formation material, energetic particles are irradiated at a high density in a pulse-like way in terms of time to all or a part of the moving basal bodies. As a result of irradiating energetic particles at a high density in a pulse-like way along with a partial supply of the film formation material, in addition to activation acceleration of energy state on each basal body surface, activation of an energy state of film formation particles to be deposited on each basal body surface is also accelerated, and the possibility that film formation particles deposited on each basal body reach a thermal equilibrium state becomes furthermore high. As a result, it is expected that formation of a thin film having various excellent performances (explained above) on each basal body surface becomes furthermore easier.

Note that, in the present disclosure, a plurality of basal bodies may be placed allover the basal body holding surface of the basal body holding means or only on a part of the basal body holding surface. Here, "allover the basal body holding surface" excludes the case of holding basal bodies only on a part of the basal body holding surface (for example, close to the outer edge, etc.).

Also, in the present disclosure, "in a pulse-like way" is used in the following meanings. Namely, a film forming material is always supplied to the basal body holding means while the film formation means is in operation, however, when focusing on a part of a plurality of moving basal bodies (for example, assuming "a reference basal body X"), a supply amount of the continuously supplied film formation material changes over time. During a certain time, a large amount is supplied to the reference basal body X, while only a small amount is supplied to the basal body X during other time later. When the irradiation means is in operation, energetic particles are always irradiated toward the basal body holding means, however, when focusing on a part of the plurality of moving basal bodies (a reference basal body Y. It does not matter if Y is identical with the X above or not.), the continuously irradiated energetic particles are irradiated to the reference basal body Y only during a certain time, while not irradiated to the reference basal body Y during other time later. Namely, there are periods of time of that the energetic particles are not irradiated to the basal body Y.

Regarding the film formation material, a state that a supply amount of continuously supplied film formation material per time to all or a part of moving basal bodies changes is defined as "in a pulse-like way". As to energetic particles, a state that continuously irradiated energetic particles are irradiated to all or a part of moving basal bodies only during certain time and not irradiated during other time later is defined as "in a pulse-like way".

The present invention is defined in the appended independent claims. Therein, "a partial supply of a film formation material" is conducted in such a manner that a ratio of the maximum value and the minimum value (maximum value / minimum value) of a supply amount of the film formation material to all or at least a part of moving basal bodies per time exceeds 5. A partial supply of a film formation material that a ratio of the maximum value and the minimum value (maximum value / minimum value) exceeds 5 in this way can be attained by arranging a film formation means in such a manner that an angle (θ1) of a line connecting the center of the film formation means and the farthest point of an outer edge of the basal body holding means with respect to a reference line in the direction along the extending direction of a vertical axis (vertical direction), which is the rotation center of the basal body holding means, becomes 60 degrees or larger.

### BRIEF DESCRIPTIONS OF DRAWINGS

[FIG. 1] FIG. 1 is a sectional view of a film formation apparatus according to an embodiment of the present invention seen from the front.
[FIG. 2] FIG. 2 is a sectional view along the line II-II in FIG. 1.
[FIG. 3] FIG. 3 corresponds to the sectional view in FIG. 2 and is a view showing locus of a move of a measurement point being away from the center of the substrate holder by a certain distance toward the radius direction when the substrate holder rotates about the center.
[FIG. 4] FIG. 4 is a graph showing a state of ion irradiation at the measurement point in FIG. 3 on an area A2 in FIG. 2.
[FIG. 5] FIG. 5 is a sectional view showing another mode corresponding to FIG. 2.
[FIG. 6] FIG. 6 is a sectional view along the line II-II in FIG. 1. FIG. 6 is also a schematic diagram showing a supply area of a film formation material in the example 4 (example) in a positional relationship with the substrate holder.
[FIG. 7] FIG. 7 corresponds to a sectional view of FIG. 6 and is a view showing loci of respective measurement points A to C being away from the center of the substrate holder by predetermined distances to the radius direction moving when the substrate holder rotates about the center.
[FIG. 8] FIG. 8 is a graph showing a state of supplies of evaporant of a film formation material at respective measurement points A to C in FIG. 7 on an area A1 in FIG. 6. FIG. 8 is a graph also showing a state of supplies of evaporant of a film formation material at the measurement points A to C in FIG. 7 on the area A1 in FIG. 6 in the example 1 (example).
[FIG. 9] FIG. 9 is a sectional view showing another mode corresponding to FIG. 6.
[FIG. 10] FIG. 10 is a sectional view showing another arrangement example of the second area (A2) in FIG. 2 and the first area (A3) in FIG. 6.
[FIG. 11] FIG. 11 is a sectional view showing another arrangement example corresponding to FIG. 10.
[FIG. 12] FIG. 12 is a sectional view showing another arrangement example corresponding to FIG. 10.
[FIG. 13] FIG. 13 is a sectional view showing another arrangement example corresponding to FIG. 10.
[FIG. 14] FIG. 14 is a sectional view showing another arrangement example corresponding to FIG. 10.
[FIG. 15] FIG. 15 is a sectional view showing another arrangement example corresponding to FIG. 10.
[FIG. 16] FIG. 16 is a sectional view showing another arrangement example corresponding to FIG. 10.
[FIG. 17] FIG. 17 is a sectional view showing another arrangement example corresponding to FIG. 10.
[FIG. 18] FIG. 18 is a sectional view showing another arrangement example corresponding to FIG. 10.
[FIG. 19] FIG. 19 is a sectional view showing another arrangement example corresponding to FIG. 10.
[FIG. 20] FIG. 20 is a sectional view showing another arrangement example corresponding to FIG. 10.
[FIG. 21] FIG. 21 is a sectional view showing another arrangement example corresponding to FIG. 10.
[FIG. 22] FIG. 22 is a sectional view showing another arrangement example corresponding to FIG. 10.
[FIG. 23] FIG. 23 is a sectional view showing another arrangement example corresponding to FIG. 10.
[FIG. 24] FIG. 24 is a schematic view showing an ion beam irradiation area in a positional relationship with respect to the substrate holder in the examples 1-1, 7 and 7-1 (examples).
[FIG. 25] FIG. 25 is a sectional view of a film formation apparatus of a conventional configuration used in the comparative examples (examples 6 and 8) of the present invention seen from the front.
[FIG. 26] FIG. 26 is a schematic view showing a supply area of a film formation material in a positional relationship with respect to the substrate holder in the examples 6 and 8 (comparative examples).
[FIG. 27] FIG. 27 is a graph showing an average value of values of a sum of transmissivity T and reflectance R (R+T) in a wavelength range of 450 to 550nm in optical filter thin film samples produced in respective examples of the examples 7 and 7-1 (examples) and example 8 (comparative example).

### DESCRIPTION OF NUMERICAL NOTATIONS

1 and 1a... film formation apparatus, 10... vacuum container, 12... substrate holder (basal body holding means), 14... substrate (basal body), 34... evaporation source (film formation source, film formation means), 34a and 38a... shutter, 34b... crucible, 38... ion source (energetic particle irradiation means), 38b... adjustment wall, 44... attachment (support means), 50... crystal monitor, 51... film thickness detection portion, 52... controller, 53... electric heater, 54... temperature sensor

### EXEMPLARY MODE FOR CARRYING OUT THE DISLCOSED SUBJECT MATTER

Below, embodiments of the invention above will be explained based on the drawings.

### <<First Embodiment>>

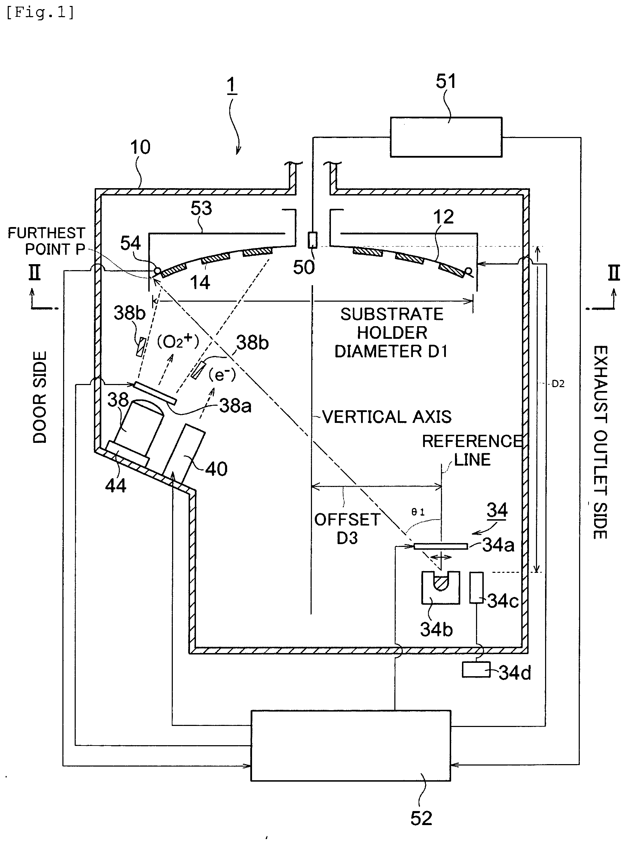

As shown in FIG. 1, a film formation apparatus 1 of the present embodiment comprises a vertical cylinder-shaped vacuum container 10.

The vacuum container 10 is a stainless-steel container having approximately a cylindrical shape like those normally used in well-known film formation apparatuses and has a ground potential. The vacuum container 10 is provided with an exhaust outlet (not shown but is on the right side when facing FIG. 1 in the present embodiment) and a vacuum pump (not shown) is connected via the exhaust outlet. By operating the vacuum pump, inside of the vacuum container 10 is exhausted to be a predetermined pressure (for example, 10⁻⁴ to 3×10⁻²Pa or so). A gas introduction tube (not shown) for introducing a gas to the inside is formed on the vacuum container 10. The vacuum container 10 may be connected to a load-lock chamber (not shown) via a door (not shown but is on the left side when facing FIG. 1 in the present embodiment).

A substrate holder 12 is held at an upper portion inside the vacuum container 10. The substrate holder 12 (basal body holding means) is a dome-shaped stainless-steel member held to be rotatable about a vertical axis and connected to an output axis (not shown rotation means) of a motor (not shown rotation means).

On the lower surface (basal body holding surface) of the substrate holder 12, a plurality of substrates 14 are held during film formation. Note that an opening is provided at the center of the substrate holder 12 of the present embodiment, where a crystal monitor 50 is provided. The crystal monitor 50 detects at a film thickness detection portion 51 a physical film thickness formed on a substrate 14 surface based on a change of a resonant frequency caused by adhesion of evaporated substances (evaporant of a film formation material) on a surface thereof. A detection result of a film thickness is sent to a controller 52.

At the upper portion inside the vacuum container 10, an electric heater 53 (heating means) is provided so as to wrap the substrate holder 12 from above. A temperature of the substrate holder 12 is detected by a temperature sensor 54, such as a thermocouple, and the result is sent to the controller 52.

The controller 52 controls an open/close state of a shutter 34a of the evaporation source 34 and a shutter 38a of the ion source 38, which will be explained later on, based on an output from the film thickness detection portion 51 and controls a film thickness of a thin film to be formed on the substrate 14 properly. Also, the controller 52 controls the electric heater 53 and manages a temperature of substrates 14 properly based on an output from the temperature sensor 54. Note that the controller 52 also manages to start operation and stop operation of the later explained ion source 38 and the evaporation source 34.

On the side surface side inside the vacuum container 10 is provided with an irradiation means for irradiating energetic particles. The ion source 38 as an example of the irradiation means is an energetic particle irradiation apparatus as a film formation assist device used mainly for the purpose of giving an ion-assisted effect to thin films to be deposited on substrates by irradiating an ion beam along with a supply of a film formation material by starting operation of the evaporation source 34 (explained later. It will be the same below). Note that the ion source 38 may be also used for the purpose of cleaning surfaces of substrates 14 by irradiating an ion beam to the substrates 14 before starting operation of the evaporation source 34.

The ion source 38 draws out positively charged ions (O₂⁺ and Ar⁺) from plasma of a reaction gas (for example, O₂) and a noble gas (for example, Ar), accelerates with an accelerating voltage and emits toward substrates 14. Above the ion source 38, a shutter 38a, which can be operated to be open and closed, is provided at a position of blocking an ion beam from the ion source 38 to the substrates 14. The shutter 38a is controlled to be open or closed properly by an instruction from the controller 52.

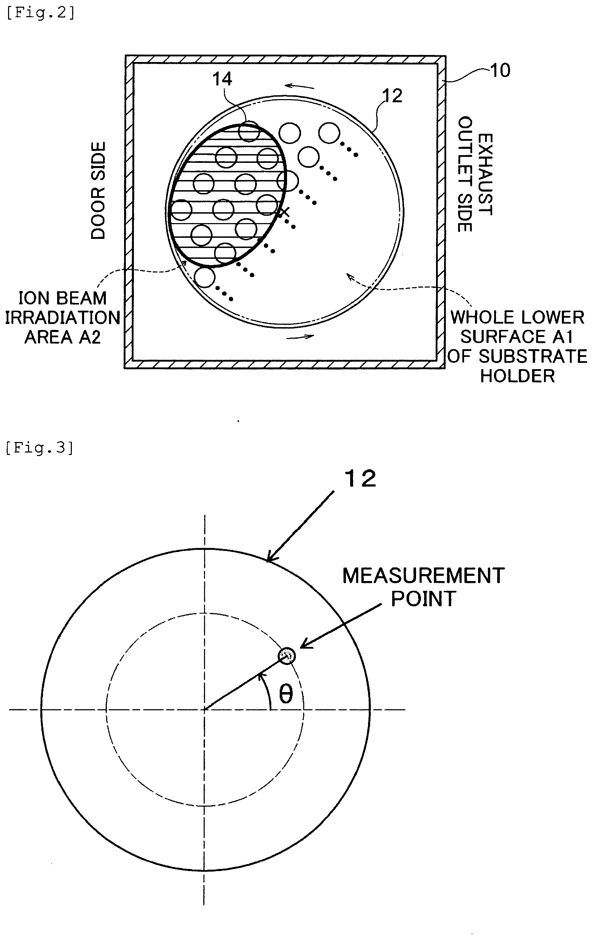

The ion source 38 of the present embodiment is, for example, as shown in FIG. 2, arranged with the configuration, an arrangement and/or direction that an ion beam may be irradiated partially only toward a second area (area A2 surrounded by a thick solid line in FIG. 2), that is a partial area of the basal body holding surface, when operated toward the substrate holder 12 while an operation of the substrate holder 12, which rotates about a vertical axis on receiving an output from a motor, is suspended (rotation stop).

Namely, in the present embodiment, the ion source 38 is arranged, in such a manner that an irradiation area (A2) of an ion beam by the ion source 38 becomes smaller than the whole lower surface (area A1 surrounded by a two-dot line in FIG. 2) that is a basal body holding surface of the substrate holder 12 (A2<A1) while rotation is suspended. It is particularly preferable to arrange the ion source 38 so as to fulfill A2≤((1/2)×A1), that is, a half or less of the whole lower surface of the substrate holder 12. Note that, in some cases, it is particularly preferable to arrange the ion source 38 so as to fulfill ((1/2)×A1) ≤A2≤((4/5)×A1), that is, 50% or greater and 80% or less of the whole lower surface of the substrate holder 12.

By arranging the ion source 38 as above and operating continuously, it is possible to temporarily secure time of not irradiating an ion beam from the ion source 38 to a plurality of moving substrates 14 along with rotation of the substrate holder 12 (partial irradiation of an ion beam). Note that as a result of continuing ion partial irradiation of the present embodiment for a predetermined period of time, it becomes eventually possible to irradiate an ion beam to all of the substrates 14 held on the rotating substrate holder 12.

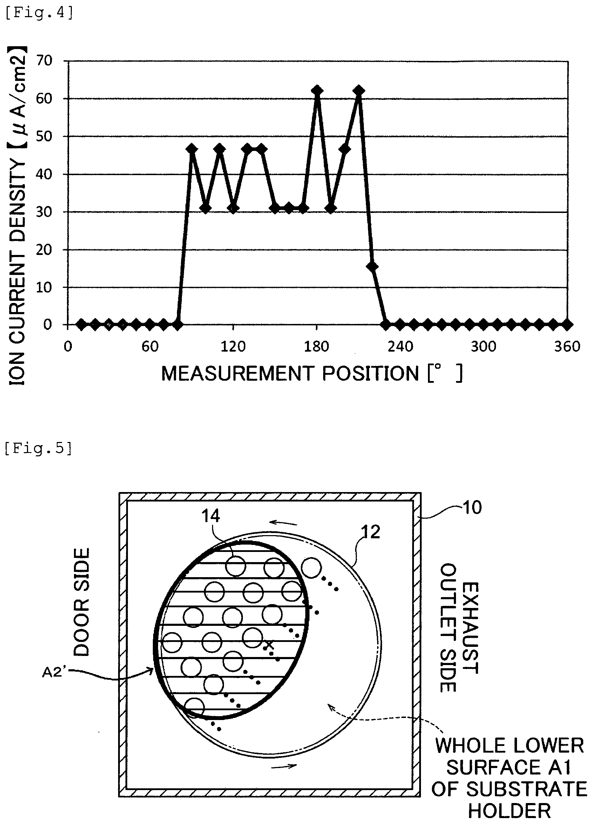

When assuming that a position of the center on an ion irradiation surface side of the substrate 12 is (x, y)=(0, 0), a point where a locus of an arbitrary measurement point leaving a predetermined distance from the center in the radius direction on the ion irradiation surface side moving as the substrate holder 12 rotates (refer to FIG. 3) crosses with the x axis in x>0 part is assumed as a reference point (measurement point = 0 degree). Here, an angle (x1, indicated as θ in FIG. 3) of a straight line connecting a position of the arbitrary point moving in the anticlockwise direction on the locus due to rotation of the substrate holder 12 and the center with respect to the X axis (limited to x>0) is taken as the X axis from 0 degree to 360 degrees and a ion current density (y1) at each x1 is taken as the Y axis from 0µA/cm² to 70µA/cm², then, values of x1 and y1 are plotted on an XY plane, and a graph thereof is shown in FIG. 4. This graph in FIG. 4 indicates an ion irradiation state at the measurement point above on the area A2 shown in FIG. 2. Note that, in measurement in FIG. 4, 0 µA/cm² is obtained as a measurement value of an ion current density on an area not irradiated with ions, however, depending on the internal structure of the apparatus and a potential structure, "a noise current" of 5µA/cm² or so is sometimes observed, for example, as a result that a trace of positively charged ions, which lost irradiation energy, flow into measurement elements of an ion current being applied to be a negative potential.

As shown in FIG. 4, it is understood that an ion current density at a measurement point changes depending on the measurement position. This means that ions are irradiated and not irradiated at the measurement point, which moves on a locus due to rotation of the substrate holder 12, depending on the measurement position. On the measurement point in this embodiment, ion irradiation starts at the 80° position, records the maximum density around 180° and finishes at the 230° position. From the result of FIG. 4, it is understood that ion irradiation in a pulse-like way is actualized along a rotation cycle.

Note that the second area where an ion beam is irradiated partially by the ion source 38 may be, for example, an area A2' surrounded by a thick solid line in FIG. 5 other than the mode in FIG. 2. However, in the mode in FIG. 5, relative irradiation time of an ion beam is sometimes different between a certain substrate 14 held near the rotation axis of the substrate holder 12 (refer to "×" in the figure) and another substrate 14 held near the outer circumference of the substrate holder 12. In this case, characteristics of all substrates 14 held by the substrate holder 12 are not uniform in some cases. Therefore, in the present embodiment, as shown in FIG. 2, it is preferable that the ion source 38 is arranged so that an ion beam can be irradiated to an area not including the rotation center, which is the rotation axis of the substrate holder 12. Irradiation of an ion beam in a pulse-like way can be actualized due to an area surrounded by a closed curve (for example, an ellipsoidal area) not including the rotation center of the substrate holder 12.

Returning to FIG. 1, in the present embodiment, adjustment walls 38b and 38b for adjusting orientation of ions drawn from the ion source 38 may be provided above the shutter 38a. By providing them, an ion beam can be irradiated to a predetermined area (for example, an area A2 in FIG. 2 and area A2' in FIG. 5, etc.) on the substrate holder 12 regardless of an arrangement of the ion source 38 explained above.

The ion source 38 of the present embodiment is attached to a side surface of the vacuum container 10 via an attachment 44 as a support device.

By attaching the ion source 38 to the side surface side of the vacuum container 10, comparing with the case of arranging it at a lower portion inside the vacuum container 10, in the same way as the evaporation source 34, an ion beam irradiated from the ion source 38 reaches the substrates 14 in a short emission distance. Consequently, it is possible to suppress a decline of kinetic energy of ions at colliding with substrates 14. Also, by letting an ion beam in a state of maintaining - high kinetic energy collide with substrates 14 surfaces from an oblique direction, a larger ion-assist effect and ion cleaning effect for the substrate 14 surfaces can be actualized. It is considered that as a result that impurity atoms on substrate 14 surfaces can be removed effectively, bonding of atoms on the substrate 14 surfaces with film formation material atoms emitted due to evaporation is accelerated and various characteristics of a thin film to be formed are improved.

The ion source 38 of the present embodiment is arranged at a closer position to substrates 14 than the arrangement position of the evaporation source 34 by at least a body length of the ion source 38. Also, a part of a side surface of the vacuum container 10 is formed to be inclined so as to be able to attach the ion source 38 easily, however, the position of attaching the ion source 38 may be arbitral. Note that the attachment position of the ion source 38 is not limited to the side surface inside the vacuum container 10 and may be at a lower part in the vacuum container 10 in the same way as the evaporation source 34. In either way, it is attached to a position at which an ion beam can be irradiated to a part of substrates 14 held by the substrate holder 12.

The attachment 44 (support means) is a support device of the ion source 38 and attached to a side surface of the vacuum container 10. The attachment 44 comprises a bracket (not shown) fixed to a side surface of the vacuum container 10, a pin (not shown) for supporting the ion source 38 side to be able to incline with respect to the bracket, and a breaking member (not shown) composed of a screw for fixing inclination of the ion source 38 at a predetermined position. Therefore, an attachment angle of the ion source 38 can be adjusted arbitrarily. Also, by providing the bracket on the vacuum container 10 side and fixing it to a position adjustable base plate (not shown), it is configured to be able to adjust not only the attachment angle but a position in the height direction and in the radius direction. The position adjustment in the height direction and the radius direction is performed by moving the base plate in the vertical direction and in the radius direction.

By changing the attachment height 'h' and the position in the radius direction of the ion source 38, the ion source 38 and the substrates 14 can be adjusted to have a proper distance. By changing the attachment angle, an incident angle and position of the ion beam to be collided with substrates 14 can be adjusted. By adjusting the position in the height direction and radius direction and the attachment angle of the ion source 38, a loss of the ion beam is suppressed to the minimum and an ion current density to the ion source 38 irradiation area (for example, A2 in FIG. 2 and A2' in FIG. 5) is adjusted to have an even distribution.

The attachment angle θ of the ion source 38 is an angle formed by an axis line of ion beam irradiation and a rotation axis line of the substrate holder 12. When the angle is too large or too small, an ion-assist effect to thin films and a cleaning effect on substrate 14 surfaces by the ion beam irradiation may possibly be reduced and an effect of improving various performances of thin films may be reduced or possibly lost.

In the present embodiment, when the attachment angle θ of the ion source 38 is in an angle range of 6 to 70 degrees, various performances of thin films to be formed on the substrate 14 surfaces are expected to be furthermore improved eventually.

Also, as far as it is in a range with which an ion beam from the ion source 38 can reach substrates 14, a method of emitting an ion beam from an oblique direction to substrate 14 surfaces does not depend on a distance between the substrates 14 and the ion source 38.

Needless to mention but the attachment angle θ above can be changed arbitrarily depending on sizes of the substrate holder 12 and the vacuum container 10 or film formation material.

The attachment height 'h' is set, so that a distance between the ion source 38 and substrates 14 becomes proper. When the attachment height 'h' is too high, the attachment angle θ becomes too large, while when the attachment height 'h' becomes too low, a distance between substrates 14 and the ion source 38 becomes long and the attachment angle θ becomes too small. Therefore, the attachment height 'h' has to be at a position capable of providing a proper attachment angle θ.

The distance between the ion source 38 and substrates 14 is preferably equal to or shorter than the mean free path 1. For example, when the mean free path 1 = 500mm, a distance between the ion source 38 and the substrates 14 is preferably 500mm or less. When the distance between the ion source 38 and the substrates 14 is equal to or less than the mean free path 1, half the number or more of ions emitted from the ion source 38 can be brought in a collisionless state to collide with the substrates 14. Since the ion beam can be irradiated to the substrates 14 while keeping high energy, the effect of improving various performances of thin films to be formed thereafter is large.

Here, "a distance between the ion source 38 and substrates 14" means a distance from the center of the ion source 38 to the center of film formation surface side of the substrate holder 12. In the same way, "a distance between the evaporation source 34 and the substrates 14" means a distance from the center of the evaporation source 34 to the center of the film formation surface side of the substrate holder 12. Also, "body length of the ion source 38" is a distance from an electrode of the ion source 38 (ion gun) to the bottom of an ion plasma discharge chamber.

The attachment position of the ion source 38 is not limited to the position on the side surface side of the vacuum container 10 and may be a position being away from a wall surface of the side surface of the vacuum container 10 using the attachment 44. Since the attachment 44 can adjust a position of the ion source 38 also in the radius direction, it can be arranged in this way easily. In that case, an ion beam can be irradiated to substrates 14 from a closer position, so that the effect of ion partial irradiation can be obtained even with low energy (power consumption).

Note that the ion source 38 may be provided on the bottom portion. In that case, the bottom portion may be provided with a base for attaching the ion source 38 thereon. Also, by attaching the ion source 38 to the side surface of the vacuum container 10, irradiation of the ion beam is not hindered by a thin film correction board (not shown) arranged between the evaporation source 34 and substrates, so that a loss of ions decreases, which is preferable.

On the side surface side inside the vacuum container 10, a neutralizer 40 is provided. The neutralizer 40 of the present embodiment is a second film formation assist device operated in the case of using the ion source 38 as a film formation assist device. A film formation material moving from the evaporation source 34 to substrates 14 adheres firmly to substrates 14 surfaces at high density due to collision energy of positive ions (ion beam) irradiated from the ion source 38. Here, the substrates 14 are charged positively due to positive ions included in the ion beam. Note that as a result that positive ions (for example, O₂⁺) emitted from the ion source 38 are accumulated on the substrates 14, a phenomenon that the entire substrates 14 are charged positively (Charge Up) occurs. When charge up occurs, abnormal discharge is caused between the positively charged substrates 14 and other members, and an impact by the discharge may sometimes results in breaking thin films (insulating film) formed on surfaces of the substrates 14. Also, as a result that the substrates 14 are positively charged, collision energy by positive ions emitted from the ion source 38 is reduced, so that density and adhesion strength, etc. of the thin films may be decreased in some cases. To eliminate those disadvantages and to electrically neutralize the positive charges accumulated on the substrates 14, a neutralizer 40 may be provided as in the present embodiment.

The neutralizer 40 of the present embodiment is a film formation assist device, which discharges electrons (e⁻) toward the substrates 14 during irradiating an ion beam by the ion source 38, draws electrons from plasma of a noble gas, such as Ar, and emits the electrons by accelerating with an accelerating voltage. The electrons emitted from here neutralize charging caused by ions adhered to the substrate 14 surfaces.

In the present embodiment, the neutralizer 40 is provided by leaving a predetermined distance from the ion source 38. Note that above the neutralizer 40, an adjustment wall (Illustration is omitted. Refer, for example, to the adjustment wall 38b) may be provided for adjusting orientation of electrons discharged from the neutralizer 40.

An arrangement of the neutralizer 40 may be at a position where it is possible to irradiate electrons to substrates 14 to neutralize, and may be an arrangement with which electrons can be irradiated to a part of all substrates 14 held by the substrate holder 12 in the same way as the ion source 38 or an arrangement with which electrons can be irradiated to all of the substrates 14 in the same way as the evaporation source 34.

The neutralizer 40 may be arranged at a position from which electrons can be irradiated to substrates 14 to neutralize. In the present embodiment, the neutralizer 40 is provided at a position close to the substrate holder 12. By providing like this, it is possible to emit electrons accurately toward an area of the substrate holder 12 to which ions irradiated from the ion source 38 adhere.

Also, when the neutralizer 40 is provided at a position being away from the ion source 38 leaving a predetermined distance, it does not cause much direct reaction with ions moving from the ion source 38 to substrates 14 and charges on the substrate holder 12 can be neutralized effectively. Therefore, even when a current value to be applied to the neutralizer 40 is set at a lower value than that in the conventional apparatus, the substrate holder 12 can be neutralized preferably. Since it is possible to supply sufficient electrons to substrate 14 surfaces, a dielectric film, such as a high refractive index film and low refractive index film, can be oxidized completely.

In the present embodiment, it is configured to have one ion source 38 and one neutralizer 40, however, it may be configured to provide two or more of them, as well. For example, it may be configured to provide a plurality of ion sources 38 and neutralizers 40 along the rotation direction of the rotating substrate holder 12. By configuring as such, it can be applied to a large-scale film formation apparatus provided with a large sized substrate holder 12 more effectively.

In the present embodiment, a film formation source as a film formation means is provided at a lower part inside the vacuum container 10. The evaporation source 34 as an example of a film formation source is a resistance heating type (direct resistance heating type or indirect resistance heating type, etc.) evaporation source in the present embodiment. The evaporation source 34 comprises a crucible (boat) 34b having a recess on top for placing a film formation material and a shutter 34a provided to be able to open and close at a position of blocking all evaporant of the film formation material discharged from the crucible 34b toward substrates 14. The shutter 34a is controlled to be open or closed by an instruction from the controller 52.

In the direct heating type, an electrode is attached to a metal boat to flow a current, and the metal boat is heated directly to make the boat itself a resistance heater so as to heat a film formation material placed in it. In the indirect heating method, the boat is not a direct heat source and it is a type that a heating device separately provided from the boat is heated, for example, by flowing a current to a deposition filament made of a rare metal, such as a transition metal, etc.

In a state that a film formation material is placed in the crucible 34b, the film formation material is heated by the boat itself or by a heating device provided separately from the boat. When opening the shutter 34a in this state, evaporant of the film formation material from the crucible 34b moves inside the vacuum container 10 toward the substrates 14 and eventually adheres to surfaces of all substrates 14.

Note that the evaporation source 34 is not limited to the resistance heating type and may be an electron beam heating type evaporation source. When the evaporation source 34 is an electron beam heating type, in the same way as above, the evaporation source 34 irradiates an electron beam (e⁻) also to the film formation material in addition to the crucible 34b and the shutter 34a, and an electron gun and electron gun power source (both are not shown) for evaporating it may be furthermore provided.

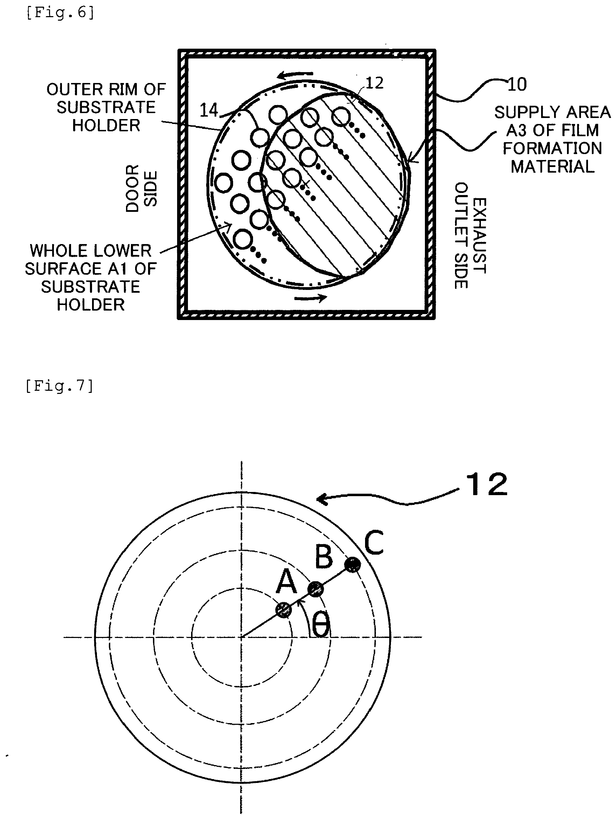

The evaporation source 34 is, for example, as shown in FIG. 6, arranged to be approached to the edge side from the approximate center arrangement at a lower part inside the container 10 so as to be able to partially supply a larger amount of evaporant of the film formation material to a first area (area A3 surrounded by a thick solid line in FIG. 6) that is a partial area of the basal body holding surface than to an area (remaining area) other than the first area when operated toward the substrate holder 21, while operation of the substrate holder 12 which rotates about a vertical axis on receiving an output from a motor is suspended (rotation stop).

Namely, in the present embodiment, it is preferable that the evaporation source 34 is arranged, in such a manner that a supply area (A3) of a film formation material by the evaporation source 34 becomes smaller than the entire lower surface (an area A1 surrounded by two-dotted line in FIG. 6) as a basal body holding surface of the substrate holder 12 in a rotation stop state (A3<A1). It is particularly preferable to arrange the evaporation source 34 so as to satisfy A3≤((1/2)×A1), that is, half or less of the entire lower surface of the substrate holder 12. Note that it is preferable in some cases to arrange the evaporation source 34 so as to satisfy ((1/2)×A1)≤A3≤((4/5×A1), that is, 50% or greater and 80% or less of the entire lower surface of the substrate holder 12.

By arranging the evaporation source 34 to be approached to the edge side inside the container 10 and operating continuously, a supply amount of the film formation material from the evaporation source 34 to a plurality of substrates 14 moving as the substrate holder 12 rotates is changed over time (partial supply of film formation material). Note that by continuing the partial supply of the film formation material of the present embodiment for a predetermined time, eventually, the film formation material can be supplied to all of the substrates 14 held by the rotating substrate holder 12.

In the present embodiment, the evaporation source 34 is preferably arranged at a position in such a manner that an angle (θ1) formed by a reference line along the extending direction of a vertical axis as the rotation center of the substrate holder 12 and a line connecting the center of the evaporation source 34 and the farthest point P on the outer edge of the substrate holder 12 becomes 40 degrees or larger, and more preferably 60 degrees or larger. By arranging the evaporation source 34 so that the angle θ1 with respect to the reference line becomes the above angle or larger, a partial supply of a film formation material can be actualized (preferably, a ratio of the maximum value and the minimum value (maximum value / minimum value) of a supply amount of the film formation material to at least a part of all moving substrates 14 per time exceeds 5 (particularly 6 or more)).

In the present embodiment, when assuming that a diameter on the film formation surface side of the substrate holder 12 is "dome diameter D1", a distance from the center of the film formation surface side of the substrate holder 12 to the center of the evaporation source 34 is "height D2" and the shortest distance from the reference line to the center of the evaporation source 34 is "offset D3", as an example, D1 may be designed, for example, to be 1000mm to 2000mm or so, D2 may be designed, for example, to be 500mm to 1500mm or so and D3 may be designed, for example, to be 100mm to 800mm or so, respectively.

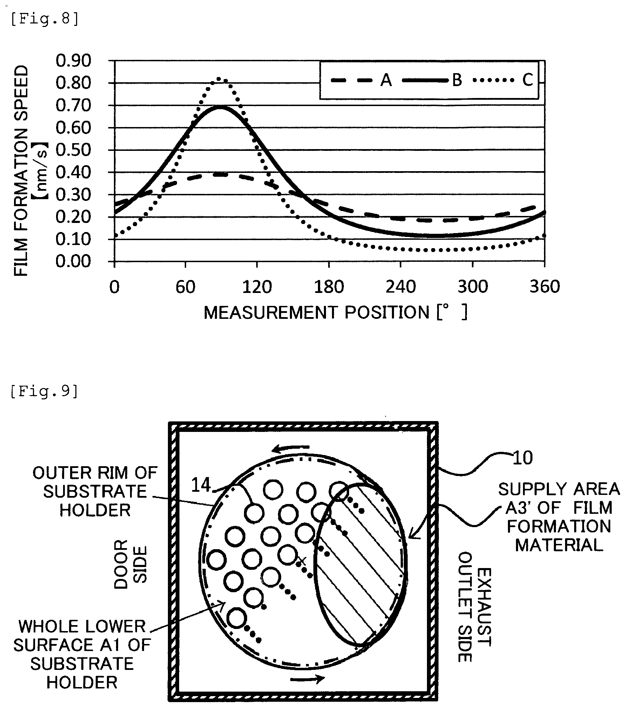

Note that when assuming that a position of the center on the film formation surface side of the substrate holder 12 is (x, y)=(0, 0), a point where respective loci of measuring points A to C (refer to FIG. 7), which are arbitral points being away from the center to the radius direction of the film formation surface side leaving predetermined distances, moving as a result of rotation of the substrate holder 12 cross with the x axis in the x>0 portion is assumed to be a reference point (measurement position = 0 degree). At this time, an angle (x1, indicated as θ in FIG. 7) of a straight line connecting each position of the measurement points A to C moving anticlockwise on the respective loci due to rotation of the substrate holder 12 and the center with respect to the x axis (limited to x>0) is taken on the X axis from 0 degree to 360 degrees, and a film formation rate (y2) at each x1 is taken on the Y axis from 0.05nm/sec. to 0.85nm/sec, and a graph plotting values of x1 and y2 on an XY plane is shown in FIG. 8. The graph in FIG. 8 shows states of supplies of evaporant of film formation material at respective measurement points A to C on the area A1 shown in FIG. 6.

As shown in FIG. 8, it is understood that a film formation rate at each measurement point changes depending on the measurement position. This means that evaporant adheres or not adheres in a pulse-like way depending on the measurement positions as to respective measurement points moving on the respective loci as a result of rotation of the substrate holder 12. Note that the evaporant adhered area corresponds to the area A3 in FIG. 6.

Note that as the first area, to which the evaporation source 34 supplies a film formation material partially, there is, for example, an area A3' surrounded by a thick solid line in FIG. 9 besides the mode in FIG. 6. In the mode in FIG. 6, a relative supply time of the film formation material sometimes differs between a certain substrate14 held close to the rotation axis of the substrate holder 12 (refer to "×" in the figure) and other substrate 14 held close to the outer circumference of the substrate holder 12. In that case, characteristics of thin films to be deposited on all substrates 14 held on the substrate holder 12 are not unified in some cases. Therefore, in the present embodiment, as shown in FIG. 9, it is preferable that an arrangement of the evaporation source 34 is adjusted so as to be able to supply a film formation material to an area not including the rotation center as the rotation axis of the substrate holder 12. When actualizing an area surrounded by a closed curve not including the rotation center of the substrate holder 12 (for example, ellipsoidal area), a supply of a film formation material in a pulse-like way can be attained.

As shown in FIG. 2 and FIG. 6, the second area (A2) as an ion beam irradiation area and the first area (A3) as a film formation material supply area may be arranged separately or arranged to be identical. Also, as shown in FIG. 2 and FIG. 6, the second area (A2) and the first area (A3) may be in an arrangement that one overlaps with the other partially or entirely.

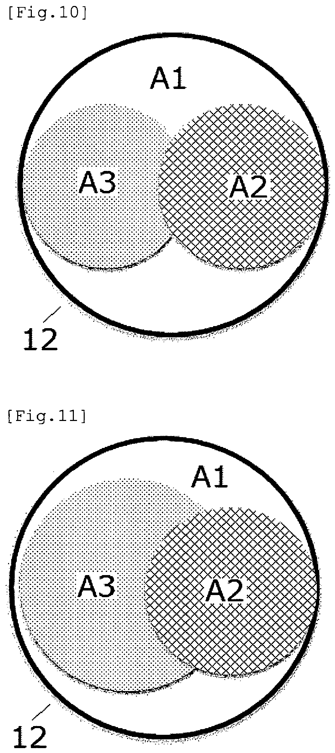

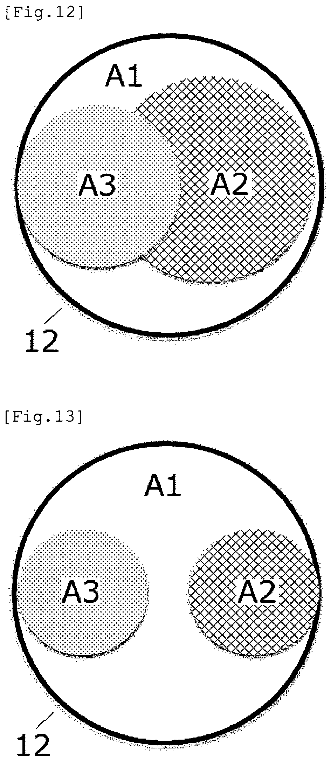

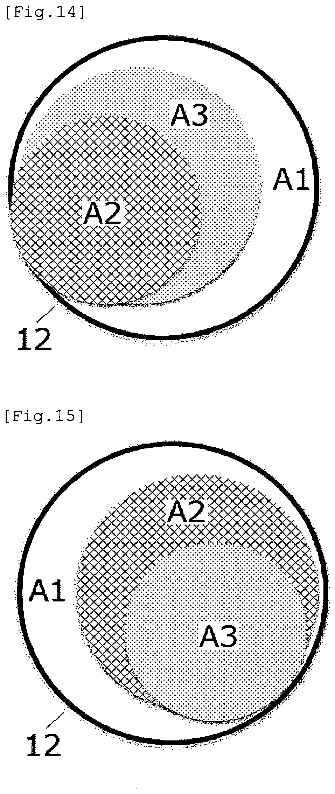

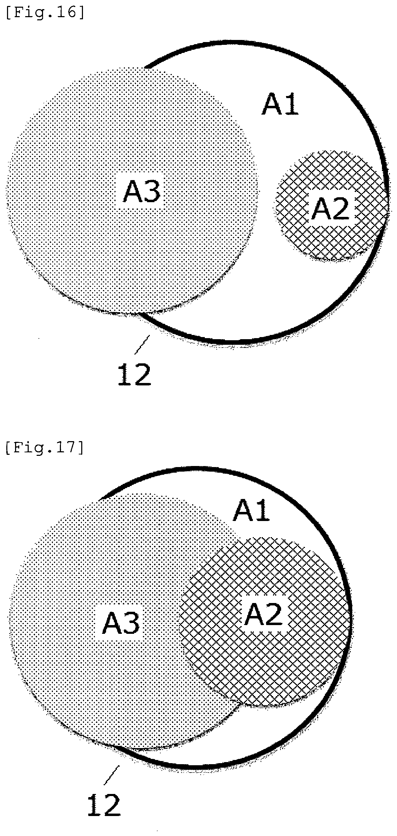

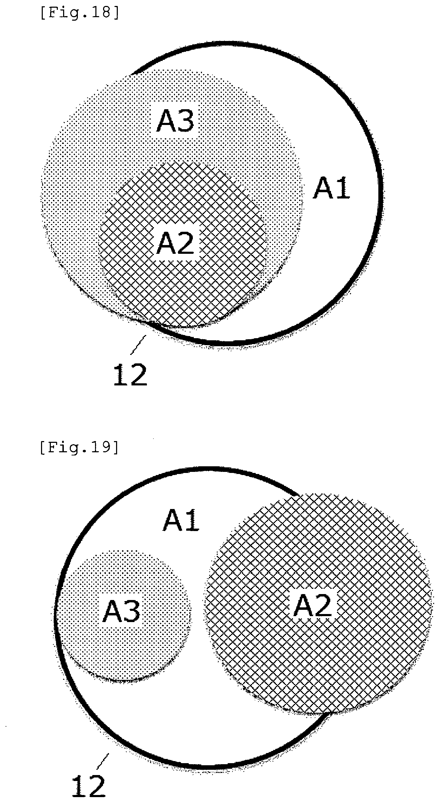

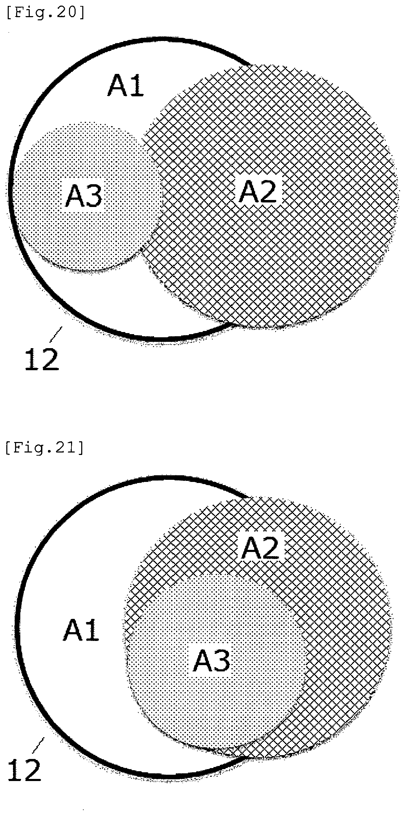

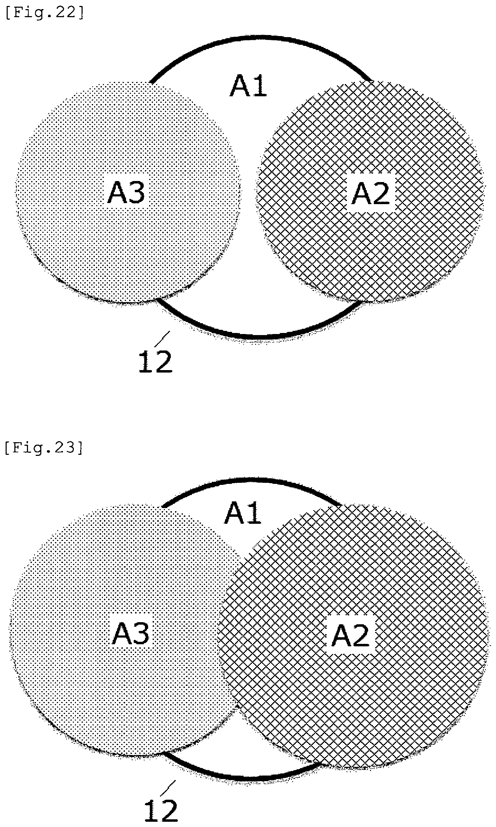

Note that arrangement examples of the second area (A2) and the first area (A3) are shown in FIG. 10 to FIG. 23. Among them, more preferable arrangements are the cases in FIG. 11 and FIG. 14.

### <<Second Embodiment>>

Next, an example of a film formation method (optical thin film formation method) using the film formation apparatus 1 will be explained.

In the present embodiment, the case of forming an optical filter thin film as an example of an optical thin film will be explained. An optical filter thin film formed in the present embodiment is formed by stacking a high refractive index substance and a low refractive index substance alternatively. However, the present invention can be applied also to formation of an optical filter composed of one or more kinds of vaporized substances (film formation material) and, in that case, the number and arrangement of evaporation source 34 may be changed arbitrarily.

Note that as a specific example of an optical filter to be produced in the present embodiment, a short wave pass filter (SWPF) and infrared cut filter are mentioned, however, other than those, it can be applied to a long wave pass filter, bandpass filter, ND filter and other thin film devices.

As an evaporation source 34, an electron beam heating type evaporation source is used in the present embodiment (An electron gun and electron gun power source are not shown. Refer to explanations on the evaporation source 34 in the first embodiment). In the present embodiment, as a film formation material for forming an optical thin film to be filled in a boat of the evaporation source 34, a high refractive index substance (for example, Ta₂O₅ and TiO₂) and a low refractive index substance (for example, SiO₂), etc. may be used.
(1) First, on the lower surface (basal body holding surface) of the substrate holder 12, a plurality of substrates 14 are set in a state that their film formation surfaces face downward. The substrates 14 (basal bodies) to be set to the substrate holder 12 may be configured by a glass, plastic or metal processed to have a shape of, for example, a plate or a lens. Note that the substrates 14 are preferably subjected to wet cleaning before or after being fixed.
(2) Next, after setting the substrate holder 12 inside the vacuum container 10, inside the vacuum container 10 is exhausted, for example, to 10⁻⁴ to 10⁻²Pa or so. When the vacuum degree is lower than 10⁻⁴Pa, it requires too much time for vacuum exhaust which may result in a decline in productivity. On the other hand, when the vacuum degree is higher than 10⁻²Pa, it is liable that film formation becomes insufficient and characteristics of films are liable to be deteriorated.
(3) Next, power is supplied to the electric heater 53 for heating and the substrate holder 12 is rotated at a predetermined speed (explained later). Due to the rotation, a temperature and film formation condition of the plurality of substrates 14 are homogenized.
   When the controller determines that the temperature of the substrates 14 became, for example, normal temperature to 120°C and preferably 50 to 90°C based on an output from a temperature sensor 54, a film formation step starts. When the substrate temperature is lower than the normal temperature, it is liable that a density of thin films to be formed becomes low and sufficient film durability cannot be obtained. When the substrate temperature exceeds 120°C, in the case of using plastic substrates as the substrates 14, the substrates 14 are liable to be deteriorated and deformed. Note that when using a material suitable to non-thermal film formation, film formation may be performed at a normal temperature. In the present embodiment, before entering the film formation step, the ion source 38 is set to be in an idle operation state. Also, the evaporation source 34 is set to be standby for dispersing (discharging) the film formation material immediately in response to an open operation of the shutter 34a.
(4) Next, the controller 52 opens the shutter 34a and supplies a film formation material to the rotating substrates 14. Simultaneously, in the present embodiment, the controller 52 increases irradiation power (power) of the ion source 38 to a predetermined irradiation power from the idle state, opens the shutter 38a and irradiates an ion beam to rotating substrates 14 (partial irradiation of ion beam). In short, ion beam assisted deposition (IAD: Ion-beam Assisted Deposition method) of the film formation material starts. During this, the neutralizer 40 starts to operate, as well.

Namely, in the present embodiment, a step of dispersing the film formation material from the evaporation source 34 to film formation surfaces of the rotating substrates 14, a step of irradiating an ion beam of an introduction gas (oxygen here) drawn from the ion source 38 and a step of irradiating electrons are performed in parallel (film formation processing).

In the present embodiment, by operating the evaporation source 34, the ion source 38 and the neutralizer 40 at the same time and continuously, on the plurality of substrates 14 moving along with rotation of the substrate holder 12, while changing a supply amount of the film formation material from the evaporation source 34 over time, and while securing time of not irradiating an ion beam from the ion source 38 and electrons from the neutralizer 40 (partial supply of film formation material and partial irradiation of ion beam), an optical filter thin film provided with an assisted effect is deposited on surfaces of all the substrates 14.

Namely, on all of the substrates 14 moving along with rotation of the substrate holder 12, film formation processing is performed by discharging in a pulse-like way evaporant of the film formation material for a predetermined period of time (T3, explained later) (partial supply of film formation material). Furthermore, in the present embodiment, the partial supply of film formation material as such is accompanied by film formation assist by an ion beam, which is partial irradiation from the oblique direction. The above are the characteristics of the present embodiment.

In another embodiment of the present invention, without opening the shutter 38a of the ion source 38 (closed state), an optical filter thin film can be also deposited on surfaces of all substrates 14 only by a partial supply of the film formation material.

In the present embodiment, when assuming that the whole discharge time of evaporant of the film formation material by the evaporation source 34 toward the substrate holder 12 is "T3", an adhering time of the evaporant per one substrate 14 held by the substrate holder 12 is "T4" and the area A3 is set to be half the area A1, T4 becomes a half of T3. In other words, even when discharging evaporant toward the substrate holder 12, for example, for 2000 seconds (T3), evaporant adhering is performed only for 1000 seconds (T4) per one substrate 14.

In the present embodiment, the evaporation source 34 is arranged so that a supply of the film formation material can be a partial supply (A3<A1). Particularly, by arranging the evaporation source 34 in the configuration of satisfying A3≤((1/2)×A1), the film formation material is preferably supplied so as to satisfy T4≤((1/2)×T3). In other case, by arranging the evaporation source 34 so as to satisfy ((1/2)xA1)≤A3≤((4/5)xA1), that is, a partial supply of the film formation material becomes 50% or greater and 80% or less of the whole area of the lower surface of the substrate holder 12, the film formation material is preferably supplied partially so as to satisfy ((1/2)×T3)≤T4≤((4/5)×T3).

Note that by arranging the evaporation source 34 so as to satisfy A3≤((1/2)×A1) and by changing the rotation speed of the substrate holder 12, the film formation material may be supplied so as to satisfy T4≤((1/2)×T3). Also, by arranging the evaporation source 34 so as to satisfy ((1/2)×A1)≤A3≤((4/5)×A1) and by changing the rotation speed of the substrate holder 12, the film formation material can be supplied so as to satisfy ((1/2)×T3)≤T4≤((4/5)×T3).

A film formation assist condition by ion beam partial irradiation is as below.

As a gaseous species to be introduced to the ion source 38 includes at least oxygen. According to the circumstances, it is a mixed gas of argon and oxygen by furthermore including argon. An introduction amount of the gaseous species above (a total introduction amount in the case of a mixed gas) is, for example, 1sccm or more, preferably 5sccm or more and more preferably 20sccm or more and, for example, 100sccm or less, preferably 70sccm or less and more preferably 50sccm or less. "sccm" is an abbreviation of "standard cubic centimeter/minutes" and indicates a volume of gas flowing per 1 minute at 0°C and at 101.3kPa (1 atmosphere).

An accelerating voltage (V) of ions is, for example, 50V or higher, preferably 100V or higher and more preferably 200V or higher and, for example, 1500V or lower, preferably 1200V or lower, more preferably 600V or lower and furthermore preferably 400V or lower.

Ion irradiation current (I) is, for example, 50mA or more, preferably 100mA or more, more preferably 200mA or more and furthermore preferably 300mA or more and, for example, 10000mA or less, preferably 800mA or less and more preferably 600mA or less.

In the present embodiment, in the case of giving an assisted effect, when assuming that the whole irradiation (whole assisted) time of the ion beam from the ion source 38 toward the substrate holder 12 is "T5", the T5 may be the same as or different from the whole discharge time (T3) of evaporant of the film formation material from the evaporation source 34 in the present embodiment. Along with T5, when assuming that the actual irradiation (actual assisted) time of the ion beam toward one substrate 14 is "T6" and when the area A2 is set to be a half of the area A1, T6 becomes a half of T5. In other words, even when ion beam irradiation for giving an assisted effect along with evaporant discharge toward the substrate holder 12 is performed, for example, for 600 seconds (T5) which is same as the evaporant discharge time (T3), actual irradiation of the ion beam for giving an assisted effect is performed only for 300 seconds (T6) per one substrate 14.

In the present embodiment, the ion source 38 is arranged so that ion beam irradiation can be partial irradiation (A2<A1). Particularly, by arranging the ion source 38 so as to satisfy A2≤((1/2)×A1), it is preferable to irradiate an ion beam so as to satisfy T6≤((1/2)×T5) for film formation assist. In other cases, by arranging the ion source 38 so as to satisfy ((1/2×A1)≤A2≤((4/S×A1), that is, a partial irradiation of the ion beam becomes 50% or greater and 80% or less of the whole area of the lower surface of the substrate holder 12, ion beam is preferably irradiated partially so as to satisfy ((1/2)×T5)((4/5)×T5) for film formation assist.

Note that by arranging the ion source 38 so as to satisfy A2≤((1/2)×A1) and by changing the rotation speed of the substrate holder 12, the ion beam may be irradiated so as to satisfy T6≤((1/2)×T5). In other cases, by arranging the ion source 38 so as to satisfy ((1/2)×A1)≤A2≤((4/5)×A1) and by changing the rotation speed of the substrate holder 12, the ion beam can be irradiated so as to satisfy ((1/2)×T5)≤T6≤((4/5)×T5).

In the present embodiment, when assuming that a period of time from a point that an arbitral substrate (reference substrate) among all the substrates 14 held by the substrate holder 12 enters the A3 area till going out along with rotation of the substrate holder 12 is "t3" and a period of time after going out from the A3 area till immediately before entering the A3 area next is "t4", it is preferable that a size of the A3, arrangement and/or rotation speed of the substrate holder 12 are determined so as to satisfy t3<t4. By setting the size of the A3 area, etc. so as to satisfy t3<t4, that is, a period of time when film formation material is supplied to the reference substrate becomes shorter than a period of time when the film formation material is not supplied, more effective and proper supply of film formation material can be attained.

Additionally, when assuming that a period of time from a point that the reference substrate enters the A2 area till going out is "t5" and a period of time after going out from the A2 area till immediately before entering the A2 area next is "t6", it is preferable that a size of the A2 area, arrangement and/or a rotation speed of the substrate holder 12 are determined so as to satisfy t5<t6. By setting the size of the A2 area, etc. so as to satisfy t5<t6, that is, a period of time irradiated becomes shorter than the period of time not irradiated with ions on the reference substrate, more effective and proper film formation assist by ion irradiation can be attained.

A total of t3 and t4 (t3+t4) and a total of t5 and t6 (t5+t6) are a period of time the substrate holder 12 rotate once, which is preferably set to 0.6 second to 20 seconds or so in the present embodiment. Namely, a rotation speed of the substrate holder 12 is set to be 3 to 100rpm or so. It is also possible to rotate the substrate holder 12 preferably at 5 to 60rpm and more preferably 10 to 40rpm.

An operation condition of the neutralizer 40 is as below.

As gaseous species to be introduced to the neutralizer 40, for example, argon may be mentioned. An introduction amount of the gaseous species above is, for example, 10 to 100sccm, preferably 30 to 50sccm. An accelerating voltage of electrons is, for example, 20 to 80V and preferably 30 to 70V. An electron current may be what allowing to supply a current larger than an ion current.

While the evaporation source 34 discharges evaporant of a film formation material, the shutter 38a of the ion source 38 is operated to be open to bring discharged ions collides with the substrates 14, consequently, surfaces of the film formation material adhered on the substrates 14 may be flat and smooth as well as densified. By repeating this operation for predetermined times, a multilayer film can be formed. Ion beam irradiation causes bias of charges on the substrates 14, however, the bias of charges is neutralized by irradiating electrons from the neutralizer 40 toward the substrates 14. In this way, a thin film having a predetermined thickness can be formed on the film formation surfaces of the substrates 14.

(5) The controller 52 keeps monitoring a film thickness of a thin film to be formed on the substrates 14 by using a crystal monitor 50 and stops film formation when reaching a predetermined film thickness. Thereby, an optical filter thin film having a predetermined film thickness is formed on each surface of substrates 14, and optical filters can be obtained. Note that the controller 52 closes the shutter 34a and the shutter 38a when stopping film formation.

According to a film formation method using the film formation apparatus 1 according to the present embodiment, an evaporation source 34 is used, which is arranged in the vacuum container 10 and configured to be able to supply a larger amount of film formation material to the area A3 that is a partial area (first area) of the basal body holding surface than to an area (remaining area) other than the area A3 when operated toward the substrate holder 12 while operation of the rotatable substrate holder 12 having a basal body holding surface for holding a plurality of substrates 14 is suspended (rotation stop). Additionally, an ion source 38 is used, which is for irradiating an ion beam only toward the area A2 that is a partial area (second area) of the basal body holding surface when operated toward the substrate holder 12 while an operation of the substrate holder 12 is suspended.

In the present embodiment, while rotating the substrate holder 12 about the vertical axis in a state of holding a plurality of substrates 14 allover the basal body holding surface, both of the evaporation source 34 and the ion source 38 are operated continuously (partial supply of film formation material and partial irradiation of ion beam).

Note that the film formation material supply area A3 is smaller than the whole area of the lower surface A1 of the substrate holder 12 (A3<A1). The ion beam irradiation area A2 is smaller than the whole area of the lower surface A1 of the substrate holder 12 (A2<A1).

Due to the continuous operation as above, a supply amount of the film formation material to all or a part of the moving substrates 14 is changed over time. Along with this, while temporarily securing a period of time of not irradiating the ion beam to all or a part of the substrates 14, a thin film made of the film formation material and provided with an assisted effect is deposited on each surface of the substrates 14.

As a result of supplying a film formation material at a high density in a pulse-like way, activation of an energy condition on the surfaces of the substrates 14 is accelerated. After that, through a multiparticle interaction, the possibility becomes high that surfaces of the substrates 14 reach a thermal equilibrium state. Thereby, comparing with the conventional method of supplying a film formation material to all of a plurality of substrates 14 held allover the basal body holding surface and rotating (film formation material supply to the whole surface), a bonding force between substrates 14 and thin films to be deposited thereon can be stronger, consequently, thin films having various excellent performances (optical characteristics of optical thin film in this embodiment) can be formed on the surfaces of the substrates 14.

Additionally, due to simultaneous irradiation of an ion beam having a high density in a pulse-like way, activation of energy condition of film forming particles to be deposited on surfaces of the substrates 14 can be accelerated in addition to accelerating activation of energy condition on surfaces of the substrates 14 explained above. Thereby, the possibility becomes furthermore higher that film formation particles deposited on surfaces of the substrates 14 reach a thermal equilibrium state. As a result, thin films having furthermore excellent performances (mentioned above) can be formed on surfaces of the substrates 14.

Particularly, in the present embodiment, since an ion beam for giving an assisted effect is partially irradiated along with a partial supply of the film formation material, a period of time when an ion beam is not irradiated to the substrates 14 is secured during supplying the film formation material. Molecules configuring the evaporated layer (evaporated molecules) deposited on the surfaces of the substrates 14 are accelerated to have a chemical reaction (oxidization) due to the ion beam during being irradiated with the ion beam, which gives an assisted effect, on the other hand, there is a possibility that kinetic energy received from the ion beam causes migration (physical excitation) on the surfaces, which is disadvantageous. In the present embodiment, during not irradiating the ion beam to the substrates 14, evaporated molecules which were migrated on their surfaces due to the ion beam irradiation can be rested (calmed down) at a stable position (stable site) on the substrate 14.

Although irradiating ions again to the evaporated molecules resting on a stable site later on, resting evaporated molecules do not move out of the stable site, consequently, it is considered that densified high quality thin films can be obtained. Namely, thin films can be densified, homogeneity in terms of composition is improved and warps in a thin film texture can be reduced. When a texture obtained by film formation has preferable homogeneity, it is possible to obtain an optical filter, wherein fluctuation of refractive index is small and a light absorption coefficient is smaller than a certain level and stable.

Note that in the case of irradiating an ion beam giving an assisted effect to the whole area of the basal body holding surface of the substrate holder 12, that is, to all of the substrates 14 continuously (irradiation to the whole surface), evaporated molecules deposited on surfaces of the substrates 14 are excited again before resting on a stable site on the substrates 14. It is because the ion beam is irradiated continuously. As a result, it is considered that it becomes difficult to leave the evaporated molecules still on the stable site, thereby, densification of thin films may be hindered.

Namely, according to the film formation method using the film formation according to the present embodiment, since an ion beam for giving an assisted effect is irradiated partially while supplying a film formation material to a part of a plurality of substrates 14 held by the substrate holder 12 and rotating, densification of thin films is furthermore accelerated comparing with that in the case of irradiating ion beam to give an assisted effect to the whole surface, consequently, a high ion-assist effect can be obtained.

### <<Third Embodiment>>

Next, another embodiment of a film formation method (film formation method of functional thin film) using the film formation apparatus 1 will be explained.

In the present embodiment, as an example of a functional thin film, the case of forming an anti-fouling film configured by an organic substance will be explained. Note that an anti-fouling film is a film having water repellency and oil repellency and has a function of preventing adhesion of greasy dirt. Here, "prevent adhesion of greasy dirt" means in addition to not allowing greasy dirt to adhere thereto but it can be easily wiped off even if it gets. Namely, an anti-fouling film maintains oil repellency.

In the present embodiment, a mode of a film formation material for forming an anti-fouling film to be filled in the boat of the evaporation source 34 is not particularly limited and, for example, (a) those obtained by impregnating a hydrophobic reactive organic compound in porous ceramic or (b) those obtained by impregnating a hydrophobic reactive organic compound in a metal fiber or fine line bundle may be used. They can absorb a large amount of hydrophobic reactive organic compound rapidly and evaporate it. Porous ceramic is preferably used in a pellet shape in terms of handleability.

As metal fibers or fine lines, for example, iron, platinum, silver and copper, etc. may be mentioned. Preferably, metal fibers or fine lines in a tangled shape, for example, woven and unwoven types are preferably used so as to be able to hold a sufficient amount of hydrophobic reactive organic compound. A cavity rate of the bundle of metal fibers or fine lines may be determined in accordance with how much hydrophobic reactive organic compound to hold.

As a film formation material, in the case of using a bundle of metal fibers or fine lines, it is preferable to keep it in a container with one end open. A metal fiber or fine line bundle kept in a container can be seen as same as a pellet. A shape of the container is not particularly limited and a Knudsen shape, tapered nozzle shape, cylinder shape, tapered cylinder shape, boat shape, filament shape, etc. may be mentioned and may be selected arbitrarily according to a specification of the film formation apparatus 1. At least one end of the container is open, and a hydrophobic reactive organic compound can evaporate from the open end. As a material of the container, copper, tungsten, tantalum, molybdenum, nickel and other metal, alumina and other ceramic and carbon, etc. may be used and selected arbitrarily according to an evaporating device and a hydrophobic reactive organic compound.

A size is not limited in both of the porous ceramic pellet and the pellet made of a bundle of metal fibers or fine lines held in a container.

When impregnating the porous ceramic or bundle of metal fibers or fine lines with a hydrophobic reactive organic compound, an organic solvent solution of a hydrophobic reactive organic compound is produced first, the solution is impregnated in the porous ceramic, metal fibers or fine lines by a dipping method, dripping method or spray method, etc., then, the organic solvent is volatilized. Since a hydrophobic reactive organic compound has a reactive group (hydrolytic group), an inert organic solvent is used preferably.

As an inert organic solvent, fluorine-modified aliphatic hydrocarbon-type solvents (perfluoriheptane, perfluorooctane, etc.), fluorine-modified aromatic hydrocarbon-type solvents (m-xylene hexafluoride, benzotrifluoride, etc.), fluorine-modified ether-type solvents (methyl perfluorobutyl ether, perfluoro(2-butyl tetrahydrofuran), etc.), fluorine-modified alkylamine-type solvents (perfluorotributylamine, perfluorotripentylamine, etc.), hydrocarbon-type solvents (toluene, xylene, etc.) and ketone-type solvents (acetone, methyl ethyl ketone, methyl isobutyl ketone, etc.), etc. may be mentioned. These organic solvents may be used alone or by mixing two or more kinds. A density of a hydrophobic reactive organic compound solution is not limitative and may be set arbitrarily in accordance with a form of carrier for impregnating the hydrophobic reactive organic compound.

In the present embodiment, operations of (1) to (3) in the second embodiment are performed. Note that in the present embodiment, the ion source 38 and the neutralizer 40 are not operated in (3) and only the evaporation source 34 is prepared to be ready for dispersing (discharging) a film formation material immediately in response to an operation of opening the shutter 34a.

(4) Next, the controller 52 opens the shutter 34a to perform vacuum deposition of the film formation material for forming an anti-fouling film by a resistance heating method (film formation processing). Note that, in the present embodiment, heating of the film formation material is not limited to the resistance heating method and a halogen lamp, sheath heater, electron beam, plasma electron beam or induction heating, etc. may be also used.

Namely, in the present embodiment, film formation processing is performed by emitting a film formation material from the evaporation source 34 to film formation surfaces of rotating substrates 14, for example, for 3 to 20 minutes (T3) (partial supply of film formation material). As a result, an anti-fouling film having a predetermined thickness (for example, 1 to 50nm) is formed on each substrate 14 surface.

(5) In the same way as in the second embodiment, the controller 52 keeps monitoring film thicknesses of thin films being formed on the substrates 14 through the crystal monitor 50 and stops the deposition when reaching predetermined film thicknesses. Thereby, anti-fouling films are formed to be predetermined film thickness on surfaces of the substrates 14, so that anti-fouling film basal bodies are obtained. Note that the controller 52 closes the shutter 38a when stopping film formation. The shutter 34a is left open throughout the process.

According to the film formation method using the film formation apparatus 1 according to the present embodiment, an evaporation source 34 is used, which is arranged in the vacuum container 10 and configured to be able to supply a larger amount of film formation material to the area A3 that is a partial area (first area) on the basal body holding surface than to an area (remaining area) other than the area A3 when operated toward the substrate holder 12 while an operation of the rotatable substrate holder 12 having a basal body holding surface for holding a plurality of substrates 14 is suspended (rotation stop).

Then, while rotating the substrate holder about the vertical axis in a state that a plurality of substrates 14 are held allover the basal body holding surface, the evaporation source 34 is operated continuously.

Thereby, while changing a supply amount of a film formation material from the evaporation source 34 to all or a part of the moving substrates 14 over time, thin films formed by the film formation material is deposited on surfaces of the substrates 14.

Due to a supply of a film formation material having a high density in a pulse-like way, activation of energy state on substrate 14 surfaces is accelerated. After that, through a multiparticle interaction, the possibility that the substrate 14 surfaces reach a thermal equilibrium state becomes high. Consequently, comparing with the conventional method of supplying a film formation material to the whole surface, a bonding force between the substrates 14 and thin films to be deposited thereon can be strengthened. As a result, it is possible to form thin films having various excellent performances (wear resistance, etc. of an anti-fouling film as a functional thin film in the present embodiment).

An anti-fouling film to be formed in the present embodiment has an improved wear resistance that an ink of an oil-based pen can be wiped off even after reciprocating steel wool #0000 for more than 1000 times (preferably 2000 times) with a load of 1kg/cm².

Note that a film formation procedure of an anti-fouling film is not limited to the procedure explained above. For example, an evaporation source other than the evaporation source 34 (for example, an electron beam heating type, etc.) may be provided at a lower part inside the vacuum container 10, an inorganic film of SiO₂ or Al₂O₃, etc. may be formed (preferably, partial supply) to be a several nm or so on surfaces of all substrates 14 held by the substrate holder 12 by using the separately provided evaporation source (illustration is omitted), then, the evaporation source 34 may be operated to form an anti-fouling film on the inorganic film. Also in this mode, wear resistance of an obtained anti-fouling film is improved comparing with that in the conventional method explained above.

### <<Other Embodiments>>

Note that in the second embodiment and the third embodiment explained above, prior to a partial supply of the film formation material, an irradiation power (power) of the ion source 38 may be increased from an idle state to a predetermined irradiation power and the shutter 38a is opened via the controller 52, and an ion beam may be irradiated to respective rotating substrates 14 (cleaning of substrate 14 surfaces by ion beam partial irradiation before starting film formation). During this, an operation of the neutralizer 40 also starts.

A cleaning condition by ion beam partial irradiation before starting film formation may be the same as the film formation assist condition in the second embodiment (explained above) or may be a different condition.

Note that an accelerating voltage (V) of ions is, for example, 50V or higher, preferably 500V or higher and more preferably 700V or higher and, for example, 1500V or lower, preferably 1300V or lower and more preferably 1200V or lower. Ion irradiation current (I) is, for example, 50mA or more, preferably 200mA or more and more preferably 400mA or more and, for example, 1500mA or less, preferably 1300mA or less and more preferably 1200mA or less.

An operation condition of the neutralizer 40 may be the same as that in the case of the film formation assist in the second embodiment (explained above) or may be a different condition.

### EXAMPLES

Next, the present invention will be explained furthermore in detail with more specific examples of the embodiments of the present invention explained above.

In each experimental example, T3 and T4 mean time during film formation and, particularly T3 is a total discharge time of evaporant of a film formation material toward the substrate holder and T4 is adhering time of the evaporant per one substrate. T5 and T6 mean ion assisted time during film formation above, particularly T5 is a total irradiation (total assist) time of an ion beam toward the substrate holder and T6 is an actual irradiation (actual assist) time of an ion beam toward one substrate. T1 and T2 mean time during cleaning, particularly T1 is a total irradiation time of an ion beam toward the substrate holder and T2 is an irradiation time of an ion beam per one substrate.

### <Experimental examples 1 to 5>

In each experimental example, the film formation apparatus 1 shown in FIG. 1 (evaporation source 34 is offset. Refer to Table 1 for designed values of a dome diameter D1, height D2, offset D3 and angle θ1) was prepared and film formation was performed under the condition below so as to obtain anti-fouling film samples. Note that BK7 (refractive index n = 1.52) was used as substrates and rotation speed (RS) of the substrate holder was 30rpm.

In film formation of an anti-fouling film, a substrate temperature at starting film formation was 100°C and the film formation condition was as below.
* film formation material: oil-repellent agent made by Canon Optron. Inc. (product name: OF-SR, compound name: fluorine-containing organic silica compound)
* T3: 500 seconds (experimental examples 1 to 5)
* T4: 100 seconds (experimental example 1, experimental example 1-1), 80 seconds (experimental example 2), 290 seconds (experimental example 3), 230 seconds (experimental example 4), 360 seconds (experimental example 5)

FIG. 6 shows a film formation material supply area (A3) in a positional relationship with the substrate holder 12 in the experimental example 4. Also, in the experimental example 1, respective states of supplies of evaporant of film formation material at respective measurement points A to C in the area A1 corresponding to the whole area of the lower surface of the substrate holder 12 shown in FIG. 6 is shown in a graph in FIG. 8.

As shown in FIG. 8, it is understood that film formation rate changes at respective measurement points depending on the measurement positions. This means that due to rotation of the substrate holder 12, evaporant adhered or not adhered depending on the measurement positions as to the measurement points moving on respective loci. For each measurement point, at a position indicating the rate maximum value (for example, a position at 90° for the measurement point C), proximity of the center of the evaporant adhering area exists, which corresponding to the area A3 in FIG. 6.

In the experimental example 1-1, as to ion irradiation (partial irradiation of ion beam) relating to substrate cleaning, a substrate temperature at starting irradiation was 100°C and an ion source condition was as below.
* introduction gaseous species and introduction amount: O₂ in an amount of 50sccm
* ion accelerating voltage: 1000V
* irradiation ion current: 500mA
* T1: 300 seconds, T2: 110 seconds
* when assuming that a substrate held at a position being offset by 560mm from the center of the substrate holder is a reference substrate, a rate of ion irradiation at substrate cleaning for the reference substrate: 35%

In the experimental example 1-1, a condition of the neutralizer was as below.
* introduction gaseous species and introduction amount: Ar in an amount of 10sccm
* electron current: 1A

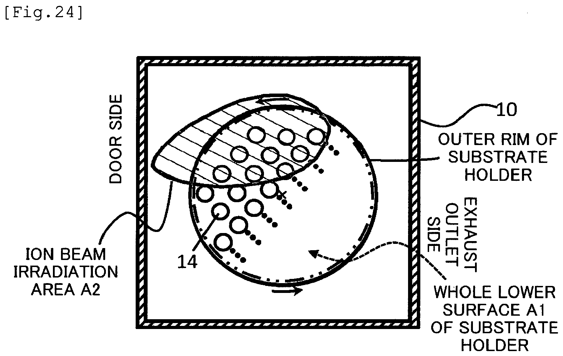

Note that FIG. 24 shows an ion beam irradiation area (A2) in the experimental example 1-1 in a positional relationship with the substrate holder 12.

### <Experimental example 6>

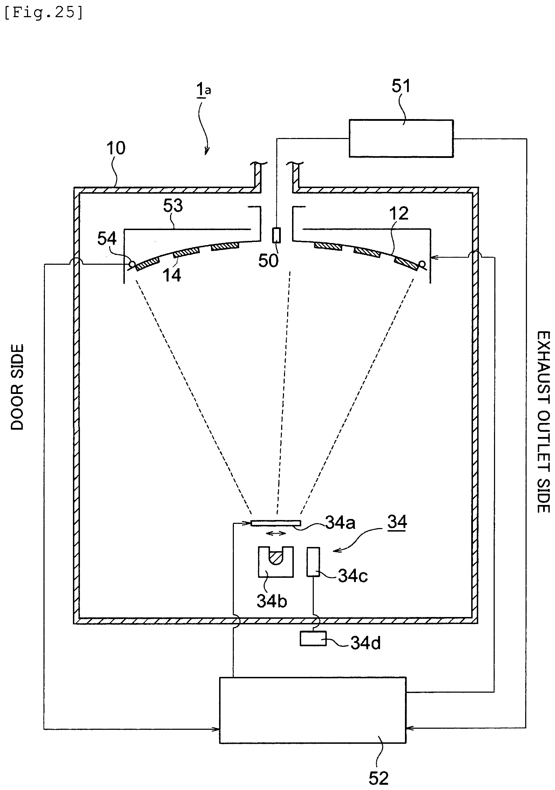

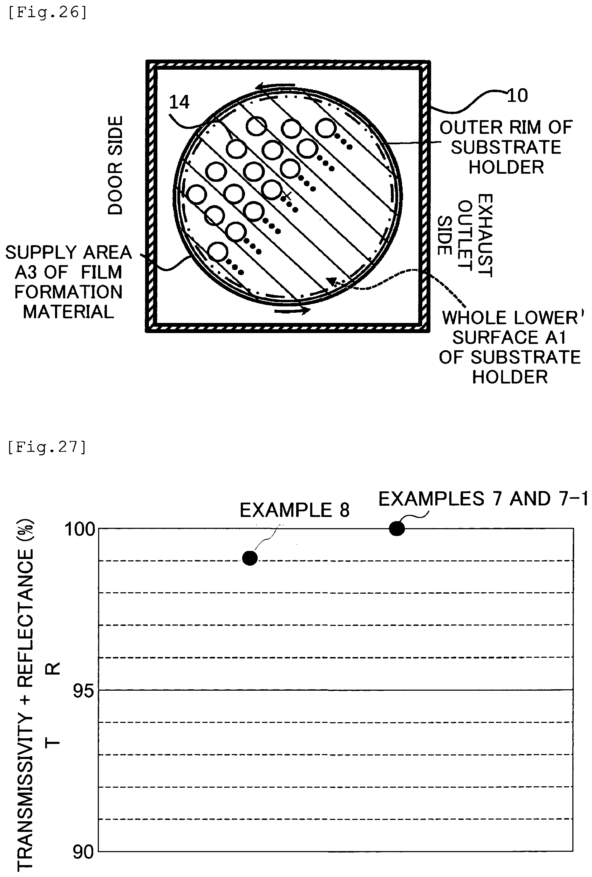

In the present experimental example, a film formation apparatus 1a shown in FIG. 25 was prepared (a conventional film formation apparatus, wherein a supply area of film formation material from the evaporation source 34 and an irradiation area of an ion beam from the ion source (illustration is omitted. The neutralizer is also omitted) are the whole area of the substrate set surface of the substrate holder 12. Refer to Table 1 for respective designed values of D1 to D3 and θ1.). By using the film formation apparatus 1a, film formation was performed under the same condition as that in the experimental examples 1 to 5 and anti-fouling samples were obtained. Note that, in the film formation apparatus 1a used in the present experimental example, a supply area (A3) of the film formation material shown in a positional relationship with the substrate holder 12 is shown in FIG. 26.
* T3: 500 seconds, T4: 500 seconds

### <Experimental example 7 and Experimental example 7-1>

In each experimental example, the same film formation apparatus as that in the experimental example 1 was prepared and optical filter thin film samples were produced under the condition below. The optical filter thin film samples are multilayer films of short wave pass filters (Short Wave Pass Filter: SWPF) each composed of 27 layers of high refractive index films and low refractive index films. As the substrate, BK7 (refractive index n = 1.52) was used and a rotation speed (RS) of the substrate holder was 30rpm.

As to the optical filter thin film formation, a substrate temperature at starting the film formation was 100°C and the film formation condition was as below.
* film formation material: Ta₂O₅ (high refractive index film) and SiO₂(low refractive index film)
* film formation speed of Ta₂O₅: 0.5nm/second
* Ta₂O₅ evaporant, T3: 2260 seconds, T4: 1620 seconds
* SiO₂ film formation speed: 1.0nm/second
* SiO₂ evaporant, T3: 1500 seconds, T4: 1075 seconds

For film formation of an optical filter thin film, ion irradiation to give an assisted effect was performed with a substrate temperature at starting irradiation of 100°C and the output condition was as below.
* introduction gaseous species and introduction amount: O₂ in an amount of 50sccm
* ion accelerating voltage: 300V
* ion irradiation current: 500mA
* when forming Ta₂O₅ film, T5: 2260 seconds and T6: 750 seconds
* when forming SiO₂ film, T5: 1500 seconds and T6: 500 seconds

A condition of the neutralizer was as below.
* introduction gaseous species and introduction amount: Ar in an amount of 10sccm
* electron current: 1A

As to ion irradiation relating to substrate cleaning in the experimental example 7-1 (partial irradiation of ion beam), a condition of an output from the ion source was as below.
* introduction gaseous species and introduction amount: O₂ in an amount of 50sccm
* ion accelerating voltage: 300V
* ion irradiation current: 500mA
* T1: 300 seconds, T2: 100 seconds
* when assuming that a substrate held at a position being offset by 560mm from the center of the substrate holder is a reference substrate, a ratio of ion irradiation to the reference substrate: 35%

In the experimental example 7-1, a condition of the neutralizer relating to substrate cleaning was as below.
* introduction gaseous species and introduction amount: Ar in an amount of 10sccm
* electron current: 1A

### <Experimental example 8>

In the present experimental example, in the same way as in the experimental example 6, the film formation apparatus 1a shown in FIG. 25 was prepared. By using the film formation apparatus 1a, film formation was performed under the same condition as in the experimental example 7 and optical filter thin film samples were obtained.
* Ta₂O₅ evaporant, T3: 2260 seconds, T4: 2260 seconds
* when forming Ta₂O₅ film, T5: 2260 seconds, T6: 2260 seconds
* SiO₂ evaporant, T3: 1500 seconds, T4: 1500 seconds
* when forming SiO₂ film, T5: 1500 seconds, T6: 1500 seconds

**[Table 1]**

| Example | Dome Diameter D1 (mm) | Height D2 (mm) | Offset D3 (mm) | Angle *θ*1 (°) |
|---|---|---|---|---|
| 1 | 1200 | 650 | 400 | 67.2 |
| 1-1 | | | | |
| 2 | 1750 | 835 | 600 | 69.5 |
| 3 | 1200 | 1050 | 300 | 45.9 |
| 4 | 1390 | 1150 | 500 | 52.6 |
| 5 | 1390 | 1150 | 385 | 40.5 |
| 6* | 718 | 780 | 100 | 34.1 |
| 7 | 1200 | 650 | 400 | 67.2 |
| 7-1 | | | | |
| 8* | 718 | 780 | 100 | 34.1 |
| "*" Comparative Example | | | | |

### <Evaluation on Maximum Number of Abrasion Reciprocation>

Wear resistance of the samples were evaluated by measuring the maximum number of abrasion reciprocation of each of the anti-fouling samples obtained in the experimental examples 1 to 6. Specifically, on each surface of the anti-fouling samples of respective experimental examples, 1cm² steel wool #0000 was placed and an abrasion test was conducted at a speed of 1 second per 1 stroke of back and forth on 50mm straight line in a state of applying a load of 1kg/cm². At every 100 strokes in the abrasion test, a line was drawn on a test surface (anti-fouling film surface) with an oil-based magic marker pen (organic solvent type marker, product name: Mckee extra fine made by ZEBURA Co., Ltd.) and the maximum number of back-and-forth strokes, with which the line by the organic solvent type ink was wiped off with a dry cloth, was measured.

As a result, the maximum number of abrasion reciprocation of the experimental example 1 samples was 3000. In the experimental examples 2 to 5, the maximum number of abrasion reciprocation was also 3000. On the other hand, the maximum number of abrasion reciprocation in the experimental example 6 samples formed by supplying a film formation material to the whole surface was 1000 and deterioration of wear resistance was confirmed comparing with samples in the experimental example 1 and experimental examples 2 to 5. However, it is considered that even "the maximum number of abrasion reciprocation: 1000" is sufficiently wear resistant and can be of practical use.
Note that the maximum number of abrasion reciprocation was 3500 in the experimental example 1-1 samples formed by cleaning substrate surfaces by ion beam partial irradiation prior to a partial supply of a film formation material, and the wear resistance was confirmed to be furthermore excellent comparing with those in the experimental example 1 and the experimental examples 2 to 5.

### <Evaluation of Water Contact Angle>

Wear resistance of the samples was evaluated by measuring a water contact angle of the anti-fouling film samples obtained in the experimental examples 1 to 6. Specifically, on each surface of the anti-fouling film samples in the respective experimental examples, 1cm² steel wool #0000 was placed and an abrasion test was conducted at a speed of 1 second per 1 stroke of back and forth on 50mm straight line for 2000 times in a state of applying a load of 1kg/cm². After that, a contact angle with water on the anti-fouling film was measured by a method based on a wettability test of JIS-R3257. More specifically, an anti-fouling film sample was mounted on a test desk, diluted water was dropped on the anti-fouling film side after abrasion, and a contact angle of the water drop in a still state was measured by using a measurer (DM500 made by Kyowa Interface Science Co., Ltd.).

As a result, a water contact angle of the experimental example 1 samples was 101 degrees. Water contact angles of respective samples in the experimental examples 2 to 5 were 101 degrees (experimental example 2), 99 degrees (experimental example 3), 100 degrees (experimental example 4) and 98 degrees (experimental example 5). On the other hand, a water contact angle of the experimental example 6 samples was 51 degrees and deterioration of wear resistance was confirmed comparing with those in the samples in the experimental example 1 and experimental examples 2 to 5.

Note that the water contact angle of the experimental example 1-1 samples was 103 degrees and wear resistance was confirmed to be excellent comparing with those in the experimental example 1 and experimental examples 2 to 5.

### <Evaluation on Spectral Characteristics>

Transmission spectral characteristics (transmissivity T) and reflection spectral characteristics (reflectance R) of optical filter thin film samples obtained in the experimental examples 7, 7-1 and 8 were measured, sums thereof (R+T) were graphed and an average value of (R+T) values in wavelength range of 450 to 550nm in particular was plotted so as to evaluate spectral characteristics of the samples. The results are shown in FIG. 27.

As a result, in both of the experimental example 7 and experimental example 7-1, absorption was not observed in the whole visible light range. Particularly, a value (R+T) in the wavelength range of 450nm to 550nm was 99.5% or greater in the experimental example 7, there was almost no absorption on the thin film (multilayer film), and it was confirmed to be a thin film having preferable optical characteristics. In the experimental example 7-1, a value of 99.8%, which is better than the result in the experimental example 7, was obtained and it was confirmed that a thin film having extremely preferable optical characteristics was formed.

On the other hand, in the experimental example 8, absorption was observed partially in the whole visible light range. Particularly, a (R+T) value in the 450nm to 550nm was 99.1%, absorption was observed a little on the thin film (multilayer film), and deterioration of optical characteristics was confirmed comparing with those in the experimental example 7 and experimental example 7-1.

Note that a processing format and evaluation results in each experimental example were listed in Table 2.

**[Table 2]**

| Example | Substrate Cleaning | Film Formation | | | | Film Formation Assist | | | | Anti-Fouling Film | | Optical Thin Film |
|---|---|---|---|---|---|---|---|---|---|---|---|---|
| | Partial Irradiation by Ion Beam | Film Formation Material | Supply | | | Energetic Particles | Irradiation | | | Maximum Number of Abration Reciprocation | Contact Angle (degree) | (R+T)Value (%) |
| | | | Range | Time (sec) | | | Range | Time (sec) | | | | |
| | | | | T3 | T4 | | | T5 | T6 | | | |
| 1 | - | Anti-Fouling | Part | 500 | 100 | - | | | | 3000 | 101 | - |
| 1-1 | Yes | | | | | | | | | 3500 | 103 | |
| 2 - | - | | | | 80 | | | | | 3000 | 101 | |
| 3 | | | | | 290 | | | | | 3000 | 99 | |
| 4 | | | | | 230 | | | | | 3000 | 100 | |
| 5 | | | | | 360 | | | | | 3000 | 98 | |
| 6* | | | Whole | | 500 | | | | | 1000 | 51 | |
| 7 | - | Filter | Part | 2260 | 1620 | Ion Beam | Part | 2260 | 750 | - | | 99.6 |
| | | | | 1500 | 1075 | | | 1500 | 500 | | | |
| 7-1 | Yes | | Part | 2260 | 1620 | | Part | 2260 | 750 | | | 99.8 |
| | | | | 1500 | 1075 | | | 1500 | 500 | | | |
| 8* | - | | Whole | 2260 | | | Whole | 2260 | | | | 99.1 |
| | | | | 1500 | | | | 1500 | | | | |
| "*" Comparative Example | | | | | | | | | | | | |

## Claims

1. A film formation method for depositing a thin film on a surface of a basal body (14), using
a rotatable basal body holding means (12) having a basal body holding surface for holding a plurality of basal bodies (14), and
a film formation means (34) arranged below the basal body holding means (12) and adapted to supply a larger amount of a film formation material of the thin film to a first partial area (A3) of the basal body holding surface than to an area other than the first area (A3) when operated toward the basal body holding means (12) in a rotation stop state,
wherein, by operating the film formation means (34) continuously while rotating the basal body holding means (12) in a state of holding a plurality of basal bodies (14) on the basal body holding surface and changing a supply amount of the film formation material to all or a part of moving basal bodies (14) over time, the thin film formed by the film formation material is deposited on all of the basal bodies (14),
wherein the basal body holding means (12) is controlled to have a rotation speed of 3 to 100 rpm about its vertical axis,
**characterized in that** a supply of the film formation material is realized by arranging a film formation means (34) in such a manner that an angle (θ1) of a line connecting the center of a film formation means (34) and the farthest point of an outer edge of the basal body holding means (12) with respect to a reference line along the vertical direction of extending a vertical axis as a rotation center of the basal body holding means (12) becomes 60 degrees or larger, and a film formation material is supplied in such a manner that a ratio of a maximum value and a minimum value (maximum value / minimum value) of a supply amount of a film formation material per time to at least a part of all moving basal bodies (14) exceeds 5.

2. The film formation method according to claim 1, **characterized by** using
an irradiation means (38) for irradiating energetic particles only toward a second partial area (A2) of the basal body holding surface when operated toward the basal body holding means (12) in a rotation stop state;
wherein, by operating the film formation means (34) and the irradiation means (38) continuously while rotating the basal body holding means (12) in a state of holding a plurality of basal bodies (14) on the basal body holding surface and changing a supply amount of the film formation material to all or a part of moving basal bodies (14) over time and temporarily securing time of not irradiating the energetic particles to all or a part of basal bodies (14), the thin film formed by the film formation material and provided with an assisted effect is deposited on all of the basal bodies (14).

3. The film formation method according to claim 2, **characterized by** supplying the film formation material and irradiating the energetic particles in such a manner that the first area (A3) and the second area (A2) are arranged separately so as not to overlap each other.

4. The film formation method according to claim 2, **characterized by** supplying the film formation material and irradiating the energetic particles in such a manner that the second area (A2) is arranged to overlap at least partially with the first area (A3).

5. A film formation apparatus (1; 1a), wherein a basal body holding means (12) having a basal body holding surface for holding a plurality of basal bodies (14) is provided to be rotatable about a vertical axis in a vacuum container (10), comprising:
film formation means (34) provided in the vacuum container (10) and configured to be able to supply a larger amount of a film formation material to a first partial area (A3) of the basal body holding surface than to a remaining area other than the first area (A3) when operated toward the basal body holding means (12) in a rotation stop state, and
irradiation means (38) provided inside the vacuum container (10) in the configuration, an arrangement and/or direction that energetic particles may be irradiated only toward a second partial area (A2) of the basal body holding surface when operated toward the basal body holding means (12) in a rotation stop state,
wherein the basal body holding means (12) is controlled to have a rotation speed of 3 to 100 rpm about its vertical axis,
**characterized in that** the film formation means (34) is arranged at a position that an angle (θ1) of a line connecting the center of a film formation source and the farthest point of an outer edge of the basal body holding means (12) with respect to a reference line along the vertical direction of extending a vertical axis as a rotation center of the basal body holding means (12) becomes 60 degrees or larger, and a film formation material is supplied in such a manner that a ratio of a maximum value and a minimum value (maximum value / minimum value) of a supply amount of a film formation material per time to at least a part of all moving basal bodies (14) exceeds 5.

6. The film formation apparatus (1; 1a) according to claim 5, wherein the irradiation means (38) is provided inside the vacuum container (10) in the configuration, arrangement and/or direction that the second partial area (A2) is separately arranged from the first area (A3) and not overlapping therewith, when operated toward the basal body holding means (12) in a rotation stop state.

7. The film formation apparatus (1; 1a) according to claim 5, wherein the irradiation means (38) is provided inside the vacuum container (10) in the configuration, arrangement and/or direction that the second partial area (A2) overlaps with at least a part of the first area (A3), when operated toward the basal body holding means (12) in a rotation stop state.

8. The film formation apparatus (1; 1a) according to any one of claims 5 to 7, **characterized in that** the film formation means (34) comprises a film formation source provided in the vacuum container (10), and the film formation source is arranged to be approached to the edge side from an approximate center arrangement at a lower portion inside the vacuum container (10) so as to be able to supply a film formation material to be discharged
to half or less of the whole area (A1) of the basal body holding surface, or
to 50% or greater and 80% or less of the whole area (A1) of the basal body holding surface.

9. The film formation apparatus (1; 1a) according to any one of claims 5 to 8, **characterized in that** the irradiation means (38) is arranged in the vacuum container (10)
in an arrangement that energetic particles may be irradiated to half or less of the whole area (A1) of the basal body holding surface, or
in an arrangement that energetic particles can be irradiated to 50% or greater and 80% or less of the whole area (A1) of the basal body holding surface.

10. The film formation apparatus (1; 1a) according to any one of claims 5 to 9, wherein the irradiation means (38) is configured by an ion source capable of irradiating an ion beam with an accelerating voltage of 50 to 1500 V.

11. The film formation apparatus (1; 1a) according to any one of claims 5 to 10, **characterized in that**
the apparatus (1; 1a) is adapted to control irradiation of energetic particles by the irradiation means (38) together with a supply of a film formation material by the film formation means (34), and/or
the film formation means (34) is arranged below the basal body holding surface.

## Patentansprüche

1. Filmbildungsverfahren zum Aufbringen eines Dünnfilms auf eine Fläche eines Basalkörpers (14), wobei verwendet wird:
eine rotierbare Basalkörper-Halteeinrichtung (12) mit einer Basalkörper-Haltefläche zum Halten mehrerer Basalkörper (14), und
eine Filmbildungseinrichtung (34), die unterhalb der Basalkörper-Halteeinrichtung (12) angeordnet und dazu ausgelegt ist, eine größere Menge eines Filmbildungsmaterials des Dünnfilms auf einen ersten Teilbereich (A3) der Basalkörper-Haltefläche als auf einen von dem ersten Bereich (A3) verschiedenen Bereich zuzuführen, wenn sie in Richtung der Basalkörper-Halteeinrichtung (12) in einem Rotationsstopp-Zustand betrieben wird,
wobei der durch das Filmbildungsmaterial gebildete Dünnfilm auf allen Basalkörpern (14) abgelagert wird, indem die Filmbildungseinrichtung (34) kontinuierlich betrieben wird, während die Basalkörper-Halteeinrichtung (12) in einem Zustand rotiert wird, in dem sie mehrere Basalkörper (14) auf der Basalkörper-Haltefläche hält, und eine Zufuhrmenge des Filmbildungsmaterials auf alle oder einen Teil von sich bewegenden Basalkörpern (14) über der Zeit geändert wird,
wobei die Basalkörper-Halteeinrichtung (12) dazu gesteuert wird, eine Rotationsgeschwindigkeit von 3 bis 100 rpm um ihre Vertikalachse zu haben,
**dadurch gekennzeichnet, dass** eine Zufuhr des Filmbildungsmaterials dadurch realisiert wird, dass eine Filmbildungseinrichtung (34) auf solche Weise angeordnet wird, dass ein Winkel (θ1) einer Linie, die die Mitte einer Filmbildungseinrichtung (34) und den entferntesten Punkt einer Außenkante der Basalkörper-Halteeinrichtung (12) verbindet, bezüglich einer Referenzlinie längs der Vertikalrichtung im Verlauf einer Vertikalachse als einem Rotationszentrum der Basalkörper-Halteeinrichtung (12) mindestens 60 Grad wird, und ein Filmbildungsmaterial auf solche Weise zugeführt wird, dass ein Verhältnis eines Maximalwerts und eines Minimalwerts (Maximalwert/Minimalwert) einer Zufuhrmenge eines Filmbildungsmaterials pro Zeit auf wenigstens einen Teil von allen sich bewegenden Basalkörpern (14) 5 überschreitet.

2. Filmbildungsverfahren nach Anspruch 1, **dadurch gekennzeichnet, dass** verwendet wird:
eine Bestrahlungseinrichtung (38) zum Ausstrahlen energetischer Partikel nur auf einen zweiten Teilbereich (A2) der Basalkörper-Haltefläche, wenn sie in Richtung der Basalkörper-Halteeinrichtung (12) in einem Rotationsstopp-Zustand betrieben wird,
wobei der durch das Filmbildungsmaterial gebildete und mit einem Hilfseffekt versehene Dünnfilm auf allen Basalkörpern (14) gebildet wird, indem die Filmbildungseinrichtung (34) und die Bestrahlungseinrichtung (38) kontinuierlich betrieben werden, während die Basalkörper-Halteeinrichtung (12) in einem Zustand rotiert wird, in dem sie mehrere Basalkörper (14) auf der Basalkörper-Haltefläche hält, und eine Zufuhrmenge des Filmbildungsmaterials auf alle oder einen Teil der sich bewegenden Basalkörper (14) über die Zeit verändert wird und temporär die Zeit des Nichtbestrahlens der energetischen Partikel auf alle oder einen Teil der Basalkörper (14) gesichert wird.

3. Filmbildungsverfahren nach Anspruch 2, **dadurch gekennzeichnet, dass** das Filmbildungsmaterial zugeführt und die energetischen Partikel derart ausgestrahlt werden, dass der erste Bereich (A3) und der zweite Bereich (A2) separat so angeordnet sind, dass sie einander nicht überlappen.

4. Filmbildungsverfahren nach Anspruch 2, **dadurch gekennzeichnet, dass** das Filmbildungsmaterial derart zugeführt wird und die energetischen Partikel derart ausgestrahlt werden, dass der zweite Bereich (A2) so angeordnet ist, dass er wenigstens teilweise mit dem ersten Bereich (A3) überlappt.

5. Filmbildungsgerät (1; 1a), wobei eine Basalkörper-Halteeinrichtung (12) mit einer Basalkörper-Haltefläche zum Halten mehrerer Basalkörper (14) dazu vorgesehen ist, um eine Vertikalachse in einem Vakuumbehälter (10) zu rotieren, mit
einer Filmbildungseinrichtung (34), die in dem Vakuumbehälter (10) vorgesehen und dazu konfiguriert ist, eine größere Menge eines Filmbildungsmaterials auf einen ersten Teilbereich (A3) der Basalkörper-Haltefläche zuführen zu können als auf einen von dem ersten Bereich (A3) verschiedenen Restbereich, wenn sie in Richtung der Basalkörper-Halteeinrichtung (12) in einem Rotationsstopp-Zustand betrieben wird, und
einer Bestrahlungseinrichtung (38), die innerhalb des Vakuumbehälters (10) in der Konfiguration, einer Anordnung und/oder Ausrichtung vorgesehen ist, dass energetische Partikel nur auf einen zweiten Teilbereich (A2) der Basalkörper-Haltefläche ausgestrahlt werden können, wenn sie in Richtung der Basalkörper-Halteeinrichtung (12) in einem Rotationsstopp-Zustand betrieben wird,
wobei die Basalkörper-Halteeinrichtung (12) dazu gesteuert wird, eine Rotationsgeschwindigkeit von 3 bis 100 rpm um ihre Vertikalachse zu haben,
**dadurch gekennzeichnet, dass** die Filmbildungseinrichtung (34) an einer Position angeordnet ist, an der ein Winkel (θ1) einer Linie, die die Mitte einer Filmbildungsquelle und den entferntesten Punkt einer Außenkante der Basalkörper-Halteeinrichtung (12) verbindet, bezüglich einer Referenzlinie längs der Vertikalrichtung im Verlauf einer Vertikalachse als einem Rotationszentrum der Basalkörper-Halteeinrichtung (12) mindestens 60 Grad wird, und ein Filmbildungsmaterial auf solche Weise zugeführt wird, dass ein Verhältnis eines Maximalwerts und eines Minimalwerts (Maximalwert/Minimalwert) einer Zufuhrmenge eines Filmbildungsmaterials pro Zeit zu wenigstens einem Teil aller sich bewegenden Basalkörper (14) 5 überschreitet.

6. Filmbildungsgerät (1; 1a) nach Anspruch 5, wobei die Bestrahlungseinrichtung (38) innerhalb des Vakuumbehälters (10) in der Konfiguration, Anordnung und/oder Ausrichtung vorgesehen ist, dass der zweite Teilbereich (A2) separat von dem ersten Bereich (A3) angeordnet ist und nicht damit überlappt, wenn sie in Richtung der Basalkörper-Halteeinrichtung (12) in einem Rotationsstopp-Zustand betrieben wird.

7. Filmbildungsgerät (1; 1a) nach Anspruch 5, wobei die Bestrahlungseinrichtung (38) innerhalb des Vakuumbehälters (10) in der Konfiguration, Anordnung und/oder Ausrichtung vorgesehen ist, dass der zweite Teilbereich (A2) mit wenigstens einem Teil des ersten Bereichs (A3) überlappt, wenn sie in Richtung der Basalkörper-Halteeinrichtung (12) in einem Rotationsstopp-Zustand betrieben wird.

8. Filmbildungsgerät (1; 1a) nach einem der Ansprüche 5 bis 7, **dadurch gekennzeichnet, dass** die Filmbildungseinrichtung (34) eine Filmbildungsquelle aufweist, die in dem Vakuumbehälter (10) vorgesehen ist, und die Filmbildungsquelle dazu angeordnet ist, der Kantenseite von einer zentrumsnahen Anordnung an einem Unterabschnitt innerhalb des Vakuumbehälters (10) angenähert zu werden, so dass sie dazu in der Lage ist, ein Filmbildungsmaterial zuzuführen, das abzugeben ist:
auf höchstens die Hälfte des Gesamtbereichs (A1) der Basalkörper-Haltefläche, oder
auf zwischen 50% und 80% des Gesamtbereichs (A1) der Basalkörper-Haltefläche.

9. Filmbildungsgerät (1; 1a) nach einem der Ansprüche 5 bis 8, **dadurch gekennzeichnet, dass** die Bestrahlungseinrichtung (38) in dem Vakuumbehälter (10) angeordnet ist:
in einer Anordnung, dass energetische Partikel auf höchstens die Hälfte des Gesamtbereichs (A1) der Basalkörper-Haltefläche ausgestrahlt werden können, oder
in einer Anordnung, dass energetische Partikel auf zwischen 50% und 80% des Gesamtbereichs (A1) der Basalkörper-Haltefläche ausgestrahlt werden können.

10. Filmbildungsgerät (1; 1a) nach einem der Ansprüche 5 bis 9, wobei die Bestrahlungseinrichtung (38) durch eine lonenquelle konfiguriert ist, die dazu in der Lage ist, einen lonenstrahl mit einer Beschleunigungsspannung von 50 bis 1500 V auszustrahlen.

11. Filmbildungsgerät (1; 1a) nach einem der Ansprüche 5 bis 10, **dadurch gekennzeichnet, dass**
das Gerät (1; 1a) dazu ausgelegt ist, die Ausstrahlung von energetischen Partikeln durch die Bestrahlungseinrichtung (38) zusammen mit einer Zufuhr von Filmbildungsmaterial durch die Filmbildungseinrichtung (34) zu steuern, und/oder
die Filmbildungseinrichtung (34) unterhalb der Basalkörper-Haltefläche angeordnet ist.

## Revendications

1. Procédé de formation de film pour déposer un film mince sur une surface d'un corps de base (14), utilisant
un moyen (12) rotatif de maintien de corps de base ayant une surface de maintien de corps de base pour maintenir une pluralité de corps de base (14), et
un moyen (34) de formation de film agencé en-dessous du moyen (12) de maintien de corps de base et adapté à fournir une quantité plus grande d'une matière de formation de film du film mince sur une première zone partielle (A3) de la surface de maintien de corps de base que sur une zone autre que la première zone (A3) lorsqu'il est opéré vers le moyen (12) de maintien de corps de base dans un état d'arrêt de rotation,
dans lequel, en opérant le moyen (34) de formation de film de façon continue tout en faisant tourner le moyen (12) de maintien de corps de base dans un état de maintien d'une pluralité de corps de base (14) sur la surface de maintien de corps de base et en changeant une quantité de fourniture de la matière de formation de film sur tout ou partie de corps de base (14) en déplacement dans le temps, le film mince formé par la matière de formation de film est déposé sur la totalité des corps de base (14),
dans lequel le moyen (12) de maintien de corps de base est commandé pour avoir une vitesse de rotation de 3 à 100 tr/min autour de son axe vertical,
**caractérisé en ce qu'**une fourniture de la matière de formation de film est réalisée en agençant un moyen (34) de formation de film de telle manière qu'un angle (θ1) d'une ligne connectant le centre d'un moyen (34) de formation de film et le point le plus éloigné d'un bord extérieur du moyen (12) de maintien de corps de base par rapport à une ligne de référence le long du sens vertical d'extension d'un axe vertical comme un centre de rotation du moyen (12) de maintien de corps de base devient 60 degrés ou plus, et une matière de formation de film est fournie de telle manière qu'un rapport d'une valeur maximum et d'une valeur minimum (valeur maximum / valeur minimum) d'une quantité de fourniture d'une matière de formation de film en temps sur au moins une partie de la totalité des corps de base (14) en déplacement excède 5.

2. Procédé de formation de film selon la revendication 1, **caractérisé par** l'utilisation
d'un moyen (38) d'irradiation pour irradier des particules énergétiques uniquement vers une deuxième zone partielle (A2) de la surface de maintien de corps de base lorsqu'il est opéré vers le moyen (12) de maintien de corps de base dans un état d'arrêt de rotation ;
dans lequel, en opérant le moyen (34) de formation de film et le moyen (38) d'irradiation de façon continue tout en faisant tourner le moyen (12) de maintien de corps de base dans un état de maintien d'une pluralité de corps de base (14) sur la surface de maintien de corps de base et en changeant une quantité de fourniture de la matière de formation de film sur tout ou partie de corps de base (14) en déplacement dans le temps et en assurant temporairement un temps de non irradiation des particules énergétiques sur tout ou partie de corps de base (14), le film mince formé par la matière de formation de film et prévu avec un effet assisté est déposé sur la totalité des corps de base (14).

3. Procédé de formation de film selon la revendication 2, **caractérisé par** la fourniture de la matière de formation de film et l'irradiation des particules énergétiques de telle manière que la première zone (A3) et la deuxième zone (A2) sont agencées séparément de façon à ne pas se chevaucher l'une l'autre.

4. Procédé de formation de film selon la revendication 2, **caractérisé par** la fourniture de la matière de formation de film et l'irradiation des particules énergétiques de telle manière que la deuxième zone (A2) est agencée de façon à se chevaucher au moins partiellement avec la première zone (A3).

5. Appareil (1 ; 1a) de formation de film, dans lequel un moyen (12) de maintien de corps de base ayant une surface de maintien de corps de base pour maintenir une pluralité de corps de base (14) est prévu pour être rotatif autour d'un axe vertical dans un récipient sous vide (10), comprenant :
un moyen (34) de formation de film prévu dans le récipient sous vide (10) et configuré pour être apte à fournir une quantité plus grande d'une matière de formation de film sur une première zone partielle (A3) de la surface de maintien de corps de base que sur une zone restante autre que la première zone (A3) lorsqu'il est opéré vers le moyen (12) de maintien de corps de base dans un état d'arrêt de rotation, et
un moyen (38) d'irradiation prévu à l'intérieur du récipient sous vide (10) dans la configuration, l'agencement et/ou le sens tels que des particules énergétiques peuvent être irradiées uniquement vers une deuxième zone partielle (A2) de la surface de maintien de corps de base lorsqu'il est opéré vers le moyen (12) de maintien de corps de base dans un état d'arrêt de rotation,
dans lequel le moyen (12) de maintien de corps de base est commandé pour avoir une vitesse de rotation de 3 à 100 tr/min autour de son axe vertical,
**caractérisé en ce que** le moyen (34) de formation de film est agencé en une position telle qu'un angle (θ1) d'une ligne connectant le centre d'une source de formation de film et le point le plus éloigné d'un bord extérieur du moyen (12) de maintien de corps de base par rapport à une ligne de référence le long du sens vertical d'extension d'un axe vertical comme un centre de rotation du moyen (12) de maintien de corps de base devient 60 degrés ou plus, et une matière de formation de film est fournie de telle manière qu'un rapport d'une valeur maximum et d'une valeur minimum (valeur maximum / valeur minimum) d'une quantité de fourniture d'une matière de formation de film en temps sur au moins une partie de la totalité des corps de base (14) en déplacement excède 5.

6. Appareil (1 ; 1a) de formation de film selon la revendication 5, dans lequel le moyen (38) d'irradiation est prévu à l'intérieur du récipient sous vide (10) dans la configuration, l'agencement et/ou le sens tels que la deuxième zone partielle (A2) est agencée séparément de la première zone (A3) et ne se chevauchant pas avec celle-ci, lorsqu'il est opéré vers le moyen (12) de maintien de corps de base dans un état d'arrêt de rotation.

7. Appareil (1 ; 1a) de formation de film selon la revendication 5, dans lequel le moyen (38) d'irradiation est prévu à l'intérieur du récipient sous vide (10) dans la configuration, l'agencement et/ou le sens tels que la deuxième zone partielle (A2) se chevauche avec au moins une partie de la première zone (A3), lorsqu'il est opéré vers le moyen (12) de maintien de corps de base dans un état d'arrêt de rotation.

8. Appareil (1 ; 1a) de formation de film selon l'une quelconque des revendications 5 à 7, **caractérisé en ce que** le moyen (34) de formation de film comprend une source de formation de film prévue dans le récipient sous vide (10), et la source de formation de film est agencée pour être approchée jusqu'au côté de bord depuis un agencement approximativement central au niveau d'une partie inférieure à l'intérieur du récipient sous vide (10) de façon à être apte à fournir une matière de formation de film devant être déchargée
sur la moitié ou moins de la totalité de la zone (A1) de la surface de maintien de corps de base, ou
sur 50% ou plus et 80% ou moins de la totalité de la zone (A1) de la surface de maintien de corps de base.

9. Appareil (1 ; 1a) de formation de film selon l'une quelconque des revendications 5 à 8, **caractérisé en ce que** le moyen (38) d'irradiation est agencé dans le récipient sous vide (10)
dans un agencement tel que des particules énergétiques peuvent être irradiées sur la moitié ou moins de la totalité de la zone (A1) de la surface de maintien de corps de base, ou
dans un agencement tel que des particules énergétiques peuvent être irradiées sur 50% ou plus et 80% ou moins de la totalité de la zone (A1) de la surface de maintien de corps de base.

10. Appareil (1 ; 1a) de formation de film selon l'une quelconque des revendications 5 à 9, dans lequel le moyen (38) d'irradiation est configuré par une source d'ions apte à irradier un faisceau d'ions avec une tension d'accélération de 50 à 1 500 V.

11. Appareil (1 ; 1a) de formation de film selon l'une quelconque des revendications 5 à 10, **caractérisé en ce que**
l'appareil (1 ; 1a) est adapté à commander une irradiation de particules énergétiques par le moyen (38) d'irradiation en même temps qu'une fourniture d'une matière de formation de film par le moyen (34) de formation de film, et/ou
le moyen (34) de formation de film est agencé en-dessous de la surface de maintien de corps de base.
